# EUROPEAN PATENT SPECIFICATION

(11) **EP 1 629 976 B1**
(45) Date of publication and mention of the grant of the patent: **28.05.2008**
(21) Application number: 05018602.2
(22) Date of filing: 26.08.2005
(51) Int. Cl.: G03F 7/09, B41C 1/10, B41N 1/08

(54) **Planographic printing plate precursors, stacks of planographic printing plate precursors , and methods of making planographic printing plates**
Flachdruckplattenvorläufer, Flachdruckplattenvorläufer-Stapel , Herstellungsverfahren von Flachdruckplatten
Précurseurs de plaques lithographiques, empilement de précurseurs de plaques lithographiques et procédé de fabrication de plaques lithographiques

(30) Priority: 30.08.2004 JP 2004250844
(43) Date of publication of application: 01.03.2006
(73) Proprietor: FUJIFILM Corporation, Minato-ku Tokyo (JP)
(72) Inventor: Koizumi, Shigeo, c/o Fuji Photo Film Co., Ltd, Haibara-gun Shizuoka-ken (JP)
(74) Representative: HOFFMANN EITLE

(56) References cited:
- EP-A- 1 167 063
- EP-A- 1 217 447
- EP-A- 1 231 510
- EP-A- 1 561 577
- PATENT ABSTRACTS OF JAPAN vol. 1997, no. 02, 28 February 1997 (1997-02-28) & JP 08 276677 A (TOMOEGAWA PAPER CO LTD; FUJI PHOTO FILM CO LTD), 22 October 1996 (1996-10-22)

## Description

### BACKGROUND OF THE INVENTION

### Technical Field

The present invention is related to a planographic plate precursor, particularly to a planographic printing plate precursor for direct printing plate making based on a digital signal from a computer or the like, a stack thereof, and a method for making a printing plate therefrom.

### Description of the related art

Conventionally, PS plates have been widely used as planographic printing plate precursors, which printing plate precursors each have a hydrophilic support and a lipophilic photosensitive resin layer layer disposed on the support. Usually, the planographic printing plate precursor is subjected to mask-exposure (surface-exposure) using a lith film, and then non-image portions are dissolved and removed to form a desired planographic printing plate. Recently, digitalization techniques have been spreading widely which process, store, and output image information electronically by using computers. In accordance with the development of digitalization techniques, new image output methods have been put into practice which are adapted to such digitalization techniques. As a result, there is a demand for computer-to-plate (CTP) techniques which comprise scanning a printing plate precursor with a radiation with high directivity such as a laser light according to digitalized image information, thereby directly producing a printing plate without using a lith film. Accordingly, it has been an important issue to develop an image-recording material adapted for such techniques.

A proposed scan-exposable planographic printing plate precursor has a constitution in which a hydrophilic support has thereon a lipophilic photosensitive resin layer (hereinafter occasionally referred to as "photosensitive layer") including a photosensitive compound capable of generating active species such as radicals and Bronsted acids upon exposure to laser light. This image-recording material is commercially available. A negative planographic printing plate can be obtained by: scanning the planographic printing plate precursor with a laser light according to digital information to generate active species which causes chemical or physical changes of the photosensitive layer, thereby insolubilizing the photosensitive layer; and then developing the planographic printing plate precursor.

A planographic printing plate precursor has been known (See, for example, Japanese Patent Application Laid-Open (JP-A) No. 10-195119). This planographic printing plate precursor has a hydrophilic support and a photopolymerizable photosensitive layer containing a photopolymerization initiator excellent in response speed, an addition-polymerizable ethylenic unsaturated compound, and a binder polymer which is soluble in an alkaline developer, and an optional oxygen-blocking protective layer on the support. A planographic printing plate with high resolution and high ink-affinity can be obtained efficiently from the planographic printing plate precursor by a simple developing treatment. The planographic printing plate has the desired characteristics.

Upon storage and conveyance, such planographic printing plate precursors are stacked. In this state, the surface on the photosensitive layer side directly contacts with the back surface of the support. When the surface on the photosensitive layer side is formed by a water-soluble protective layer and the stacked planographic printing plate precursors are stored under high humidity, the surface adheres to the back surface of the support and it is not easy to separate the respective planographic printing plate precursors, whereby the productivity is decreased. When the planographic printing plate precursors adhered to each other are peeled off each other, there is a problem that the surface on the photosensitive layer side partially adheres to the back surface of the support to generate defects in the photosensitive layer.

In order to prevent occurrence of such a problem, when planographic printing plate precursors are stacked, a protective paper (inserting paper) is placed between the planographic printing plate precursors so as to prevent direct contact between the planographic printing plate precursors. However, the operating efficiency is lowered in continuous planographic printing plate making from the planographic printing plate precursors because of the necessity to remove the protective paper. Further, the inserting paper is unnecessary after use, and the disposal of the inserting paper causes heavy load.

Another method for prevention of the adhesion between the stacked planographic printing plate precursors is proposed, for example, in JP-A No. 2002-225453. In this method, an organic polymer with a Tg of 20 °C or higher is provided as a backcoat layer of the planographic printing plate precursor by coating.

Another method is disclosed, for example in JP-A No. 2002-296768. In this method, the planographic printing plate precursor is a negative image-recording material having an image-recording layer on a support. The image-recording layer contains (A) a radical generator, and (B) a radical-polymerizable compound. A compound containing an aliphatic hydrocarbon group is added to the image-recording layer such that the compound is localized on the surface of the image-recording layer. By decreasing the static friction coefficient between the image-recording layer surface and the back surface of the support to less than 0.50 in this manner, fogging caused by the friction during conveyance is prevented without using inserting paper.

However, even in such a method, when the surface of each planographic printing plate precursor is smooth, the planographic printing plate precursors are hard to be peeled off each other, and cannot be conveyed separately. This is because the adhesiveness between planographic printing plate precursors is so high to remove nearly the entire air layer between the planographic printing plate precursors and to cause blocking.

### SUMMARY OF THE INVENTION

Considering the problems of the conventional techniques, the inventor has conducted intensive study. Focusing on the smoothness of the back surface of the aluminum support, the inventor has made the present invention.

The invention provides a planographic printing plate precursor. The planographic printing precursor comprises an aluminum support having a hydrophilic front surface, and a negative recording layer provided on the hydrophilic front surface of the aluminum support. The negative recording layer comprises a compound which generates a radical upon application of radiation or heat, a polymerizable compound, and a radiation absorber. The back surface of the planographic printing plate precursor has a Bekk smoothness of 1,000 seconds or less. In this specification, the front surface of the planographic printing plate precursor refers to such a surface that the negative recording layer is disposed between the aluminum support and the front surface of the planographic printing plate precursor. The back surface of the planographic printing plate precursor refers to the opposite surface to the front surface of the planographic printing plate precursor. The front surface of the support refers to the surface on which the negative recording layer is provided or to be provided. The back surface of the support refers to the opposite surface to the front surface of the support.

The back surface of the planographic printing plate precursor is formed by a surface-roughening of the back surface of the aluminum support.

The invention also provides a stack of planographic printing plate precursors comprising a plurality of planographic printing plate precursors. The planographic printing plate precursors are the planographic printing plate precursors of the invention described above. In the stack, the front surface of one planographic printing plate precursor contacts the back surface of the next planographic printing plate precursor.

The invention further provides a method of making a planographic printing plate. The method comprises: placing the stack of the planographic printing plate precursors of the invention in a plate setter; automatically conveying the planographic printing plate precursors one by one; and subjecting the respective planographic printing plate precursors to imagewise exposure.

### DESCRIPTION OF THE PRESENT INVENTION

### Planographic Printing Plate Precursor

The planographic printing precursor of the invention comprises an aluminum support having a hydrophilic surface, and a negative recording layer provided on the hydrophilic surface of the aluminum support. The negative recording layer comprises a compound which generates a radical upon application of radiation or heat, a polymerizable compound, and a radiation absorber. The back surface of the planographic printing plate precursor has a Bekk smoothness of 1,000 seconds or less. This is achievable by roughening and then anodizing the back surface. In this specification, the term radiation refers to an electromagnetic radiation such as infrared rays, ultraviolet rays, and visible rays.

Owing to the Bekk smoothness in the above range, the adhesion between the back surface of one planographic printing plate precursor and the front surface of the adjacent planographic printing plate precursor is reduced when inserting paper is not used. Accordingly, the planographic printing plate precursors of the invention are excellent in peeling property. When the planographic printing plate precursors are stored and conveyed in a stacked state, the handling of the planographic printing plate precursors are not deteriorated because of the excellent peeling property.

The back surface of the planographic printing plate precursor is the back surface of the support itself.

In an embodiment, the front surface of the planographic printing plate precursor is the surface of the negative recording layer. In another embodiment, the front surface of the planographic printing plate precursor is the surface of an overcoat layer described below. In another embodiment, the front surface of the planographic printing plate precursor is .the surface of an arbitrary layer other than the above.

### Aluminum Support

The aluminum support (hereinafter occasionally referred to as simply "support") used in the invention may be a plate comprising aluminum or an aluminum alloy, or a support obtained by adhering aluminum plate or an aluminum alloy plate to both sides of paper or plastic. The aluminum plate is preferably a pure aluminum plate, an alloy plate containing aluminum as the main component and trace amounts of heteroelements, a plastic film laminated with aluminum, or a plastic film on which aluminum is deposited. Examples of the heteroelements contained in the aluminum alloy include silicon, iron, manganese, copper, magnesium, chrome, zinc, bismuth, nickel, and titanium. The content of the heteroelements in the alloy is preferably 10% by weight or lower. Although a pure aluminum plate is preferable, production of absolutely pure aluminum is difficult from the viewpoint of refining techniques. The aluminum plate used in the invention may be an aluminum plate containing trace amounts of heteroelements. The composition of the aluminum plate is not limited, and any aluminum plates made of known and conventionally used material can be used in accordance with the necessity. Examples thereof include JIS A 1050, JIS A 1100, JIS A 3003, JIS A 3103, and JIS A 3005, the disclosures of which are incorporated herein by reference.

The thickness of the aluminum plate used in the invention is usually about 0.1 to 0.6 mm

### 1. Surface Treatment on Aluminum Support

The front surface of the aluminum plate to which the negative recording layer is to be provided may be subjected to the following treatments so as to acquire hydrophilicity.

First, the surface of the aluminum support (aluminum plate) is roughened. For example, the roughening may be conducted by: a mechanical surface roughening, an electrochemical surface roughening (method of electrochemically dissolving the surface) or a chemical surface roughening (method of chemically and selectively dissolving the surface). The mechanical surface roughening method may be a known method such as ball grinding, brush grinding, blast grinding, or buff -grinding. The electrochemical roughening method may be a method of roughening the surface in an electrolysis solution containing hydrochloric acid or nitric acid with alternating current or direct current, or a combination method of a mechanical roughening method and an electrochemical roughening method as described in JP-A 54-63902, the disclosure of which is incorporated by reference herein.

Before the surface of the aluminum plate is roughened, the aluminum plate may be subjected to a degreasing treatment with e.g. a surfactant, an organic solvent or an aqueous alkali solution so as to remove the rolling oil from the surface, in accordance with the necessity.

In an embodiment, the aluminum plate whose surface has been roughened is subjected to an alkali etching treatment, then to a neutralization treatment, then to an anodizing treatment which improves the water-retaining property and the abrasion resistance of the surface. The electrolyte used in the anodizing treatment of the aluminum plate may be any electrolyte capable of forming a porous oxide film. Generally, the electrolyte is selected from sulfuric acid, hydrochloric acid, oxalic acid, chromic acid, or a mixed acid thereof. The concentration of the electrolyte is determined suitably in accordance with the type of the electrolyte.

The conditions for the anodizing treatment may be changed depending on the electrolyte and cannot be generalized. Usually, the concentration of the electrolyte is preferably 1 to 80% by weight, the liquid temperature is preferably 5 to 70°C, the current density is preferably 5 to 60 A/dm², the voltage is preferably 1 to 100 V, and the electrolysis time is preferably 10 seconds to 5 minutes. The method for the anodization is preferably a method of anodizing at a high current density or a method of anodizing in a low-concentration aqueous sulfuric acid solution. The former and latter methods are respectively disclosed in British Patent No. 1,412,768 and U.S. Patent No. 4,211,619, the disclosures of which are incorporated herein by reference. The method is more preferably a method in which a direct current is used at 5 to 20 A/dm² in an electrolytic solution having a sulfuric acid concentration of 5 to 20 % by mass and a dissolved aluminum ion content of 3 to 15 % by mass at 25 °C to 50 °C.

The amount of the anodic oxide film on the front surface of the aluminum support is preferably 1.0 g/m² or larger, more preferably 2.0 to 6.0 g/m², so as to obtain high printing durability and excellent flaw resistance of a non-image region of the planographic printing plate, and so as to prevent adhesion of ink to the flaw portion during printing. When the amount of the anodic oxide film is 1.0 g/m² or larger, occurrence of stains caused by the flaws is sufficiently prevented.

Although the anodizing treatment is conducted on the support surface to be used for printing (the support surface on which the negative recording layer is to be provided), an anodizing film with a thickness of 0.01 to 3 g/m² is usually formed on the back surface of the support such that the thickness is larger near the edge of the support and that the thickness is smaller in the center region. This is because the line of electric force reaches also on the back surface.

After anodizing treatment, the aluminum support is optionally subjected to a hydrophilicity-imparting treatment. Examples of methods for imparting hydrophilicity include: alkali metal silicate methods disclosed in USP Nos. 2714066, 3181461, 3280734, and 3902734 (the disclosures of which are incorporated herein by reference). The alkali metal silicate may be, for example, an aqueous sodium silicate solution. In this method, the support is immersed in an aqueous sodium silicate solution or subjected to an electrolysis treatment in an aqueous sodium silicate solution.

Examples of the hydrophilicity-imparting treatment further include: a method disclosed in JP-B No. 36-22063 (the disclosure of which is incorporated herein by reference), the method comprising treating the support with potassium fluorozirconate; and methods disclosed in USP Nos. 3276868,4153461, and 4689272 (the disclosures of which are incorporated herein by reference), the methods comprising treating the support with polyvinyl phosphonic acid.

The planographic printing plate precursor of the invention may be produced by forming the negative recording layer described below on the aluminum support which has been subjected to surface treatments as described above. An organic or inorganic undercoat layer may be provided prior to the application of the negative recording layer.

### 2. Back Surface of Aluminum Support

In the invention, the back surface of the planographic printing plate precursor has a Bekk smoothness of 1000 seconds or less.

The "Bekk smoothness" refers to the time (second) a specific amount of atmospheric air takes to leak through the interface between the test piece and a ring-shaped plane; a specific original differential pressure is applied to cause leakage and the test piece and the ring-shaped plane contact each other under specific conditions. In the invention, the Bekk smoothness of the back surface of the planographic printing plate precursor is measured by a method disclosed in JIS P 8119 (1998), which is incorporated herein by reference. It is preferable to use an air-micrometer-type testing instrument in order to measure the Bekk smoothness accurately. Particularly, Oken-type smoothness measurement described in JAPAN TAPPI paper pulp measuring method No. 5 (which is incorporated herein by reference) enables simple measurement with high reproducibility.

In the invention, the Bekk smoothness of the back surface of the planographic printing plate precursor is 1,000 seconds or less. In order that the planographic printing plate precursors stored in the stack for long time each can be peeled and conveyed without troubles, the Bekk smoothness is preferably 500 seconds or less, more preferably 300 seconds or less. When the Bekk smoothness is more than 1000 seconds, it may be difficult to peel the respective planographic printing plate precursor off the stack of the planographic printing plate precursors.

The Bekk smoothness of the back surface of the planographic printing plate precursor is adjusted within the above range, for example by (1) directly roughen the back surface of the aluminum support so as to set the Bekk smoothness of the back surface of the aluminum support in the above range.

The method (1) for controlling the Bekk smoothness is described first. The roughening of the back surface of the aluminum support may be conducted in the same manner as the roughening (graining) of the front surface of the aluminum support (the surface on the side on which the recording layer is to be provided). The graining treatment may be mechanical graining such as disclosed in JP-A No. 56-28893 (the disclosure of which is incorporated herein by reference), a chemical etching, or an electrolytic graining. Examples of the graining further include: an electrochemical graining in which graining is conducted electrochemically in an electrolytic solution of hydrochloric acid or nitric acid; and a mechanical graining method such as a wire-brush graining method in which the surface of the aluminum support is scratched by a metal wire, a ball graining method in which the surface of the aluminum support is grained by using grinding balls and an abrasive, and a brush graining method in which the surface is grained by using a nylon brush and an abrasive. Only a single graining method may be employed, or two or more graining methods may be employed in combination.

The surface roughness of the support after surface-roughening treatment is preferably such that Ra is 0.15 to 0.7 µm, more preferably 0.2 µm to 0.5 µm. When Ra is smaller than 0.15 µm, the surface roughening is insufficient for realizing a Bekk smoothness of 1000 seconds or less, whereby the peelability of the planographic printing plate precursors in the stack is not sufficient. When Ra is larger than 0.7 µm, the friction resistance of the back surface of the support is small, and there may be problems of collapse of cargo upon transport of the stack of the planographic printing plate precursors; further, roughening to such a degree causes more troubles to the process.

Anodization is conducted on the back surface of the support which has been subjected to the roughening treatment. The anodization prevents occurrence of flaws on the back surface of the aluminum support during transport or conveyance. The amount of the anodic oxide film on the back surface of the support is preferably 0.1 g/m² or larger. In a preferable embodiment, after the graining-roughening of the front and back surfaces of the support is completed, the anodization of the front and back surface of the support is conducted simultaneously.

### Negative Recording Layer

The negative recording layer of the planographic printing plate precursor of the invention is a radical-polymerizable layer. The radical-polymerizable layer comprises (A) a radiation absorber, (B) a compound (hereinafter occasionally referred to as "radical polymerization initiator") which generates a radical upon application of heat or radiation, (C) a polymerizable compound which polymerize to cure upon reaction with the generated radical. In a preferable embodiment, the radical-polymerizable layer further includes (D) a binder polymer.

When an image is formed on the negative recording layer, (i) the radical polymerization initiator is decomposed by exposure radiation and/or heat generated by conversion of the radiation absorbed by the radiation absorber, thereby generating a radical, or (ii) an electron is transferred from the radiation absorber which has absorbed the radiation to the radical polymerization initiator such as triazine, thereby generating a radical. Then, the radical initiates a chain reaction polymerization of the polymerizable compound to cure the exposed region and to form an image. The polymerizable compound is selected from compounds having at least one ethylenic unsaturated double bond and having at least one (preferably at least two) terminal ethylenic unsaturated bond.

### (A) Radiation Absorber

The negative recording layer of the planographic printing plate precursor of the invention may be capable of forming an image by using various exposure radiation sources. In the negative recording layer, a radiation absorber capable of absorbing the exposure radiation is used from the viewpoint of recording sensitivity.

In the following, an infrared absorber as a typical example of the radiation absorber is described. The infrared absorber has a function of converting the absorbed infrared ray to heat. The generate heat causes the radical polymerization initiator to generate a radical. The infrared absorber used in the invention is a dye or pigment having an absorption peak in the wavelength range of 760 nm to 1200 nm.

The dye may be selected from commercially available dyes and known dyes described in e.g. "Senryo Binran" (Dye Handbook) (published in 1970 and compiled by Society of Synthetic Organic Chemistry, Japan, the disclosure of which is incorporated by reference herein). Specifically, the dye may be selected, for example from the dyes described in paragraphs [0050] to [0051] of JP-A No. 10-39509, the disclosure of which is incorporated herein by reference.

Examples of the dye include cyanine dyes, squarylium dyes, pyrylium salts and nickel thiolate complexes. Cyanine dyes are preferable and cyanine dyes represented by the following formula (a) are more preferable.

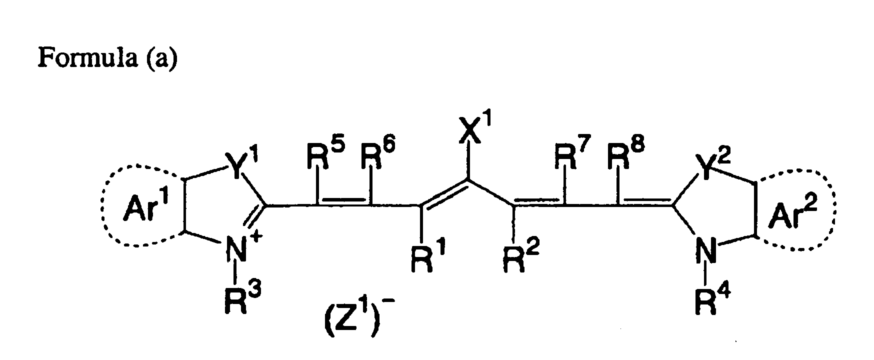

In the formula (a), X¹ represents a hydrogen atom or -X²-L¹. X² represents an oxygen atom or sulfur atom, and L¹ represents a C₁₋₁₂ hydrocarbon group. R¹ and R² each independently represent a C₁₋₁₂ hydrocarbon group. From the viewpoint of the storage stability of the negative recording layer coating liquid, each of R¹ and R² is preferably a hydrocarbon group having 2 or more carbon atoms. In a preferable embodiment, R¹ and R² are bound to each other to form a 5- or 6-memberred ring.

Ar¹ and Ar² may be the same as or different from each other. Ar¹ and Ar² each independently represent an aromatic hydrocarbon group which may have a substituent. Y¹ and Y² may be the same as or different from each other, and each independently represent a sulfur atom or a dialkyl methylene group having 12 or less carbon atoms. R³ and R⁴ may be the same as or different from each other, and each independently represent a hydrocarbon group having 20 or less carbon atoms, which may have a substituent. The substituent is preferably an alkoxy group having 12 or less carbon atoms, a carboxyl group or a sulfo group. R⁵, R⁶, R⁷ and R⁸ may be the same as or different from each other, and each independently represent a hydrogen atom or a hydrocarbon group having 12 or less carbon atoms. Each of R⁵, R⁶, R⁷ and R⁸ is preferably a hydrogen atom because the starting material is easily available. (Z¹)⁻ represents a counter anion. However, when the cyanine dye represented by the formula (a) has an anionic substituent in its structure and thus neutralization of the charge is not necessary, (Z¹)⁻ can be omitted. From the viewpoint of the storage stability of the negative recording layer coating liquid, (Z¹)⁻ is preferably a halogen ion, a perchlorate ion, a tetrafluoroborate ion, a hexafluorophosphate ion or a sulfonate ion, particularly preferably a perchlorate ion, a hexafluorophosphate ion or an aryl sulfonate ion.

As examples of the cyanine dyes represented by the formula (a), the cyanine dyes described in columns [0017] to [0019] of JP-A No. 2001-133969 (the disclosure of which is incorporated by reference herein) may be cited.

Examples of the pigment usable in the invention includes commercially available pigments and the pigments described in Color Index (C. I.) Handbook, "Saishin Ganryo Binran" (Newest Dye Handbook) (published in 1977 and compiled by Japanese Society of Pigment Technology), "Saishin Ganryho Oyo Gijyutsu" (Newest Pigment Applied Technology) (published in 1986 by CMC), and "Insatsu Inki Gijyutsu" (Printing Ink Technology) (published in 1984 by CMC). The disclosures of these books are incorporated herein by reference.

Examples of usable pigments include black pigments, yellow pigments, orange pigments, brown pigments, red pigments, violet pigments, blue pigments, green pigments, fluorescent pigments, metallic powder pigments, and other pigments such as polymer-binding dyes. Details of these dyes are described in paragraphs [0052] to [0054] of JP-A No. 10-39509 (the disclosure of which is incorporated herein by reference), and may be applied to the present invention. Among the dyes, carbon black is preferable.

The content of the dye or pigment in the negative recording layer is preferably 0.01 to 50 % by mass, more preferably 0.1 to 10 % by mass, based on the mass of the total solid of the negative recording layer. In the case of the dye, the content is still more preferably 0.5 to 10 % by mass. In the case of the pigment, the content is still more preferably 1.0 to 10 % by mass.

When the content is lower than 0.01 % by mass, the sensitivity may be reduced. When the content is over 50 % by mass, there may occur stains in non-image regions of the planographic printing plate precursor.

### (B) Radical polymerization initiator

The radical polymerization initiator used in the negative recording layer of the planographic printing plate precursor has a function of initiating and promoting the curing reaction of the polymerizable compound described later. The radical-polymerizable compound may be any compound which generates a radical upon application of energy, such as: a thermal-decomposition-type radical generator which is decomposed by heat to generate a radical; an electron-transfer-type radical generator which receives an activated electron from the radiation absorber to generate a radical; or an electron-transfer-type radical generator which donates an electron to the activated radiation absorber to generate a radical.

The radical polymerization initiator may be, for example, an onium salt, an active halogen compound, an oxime ester compound, or a borate compound. In an embodiment, radical generators of respectively different radical generating mechanisms are used simultaneously. In the invention, the radical polymerization initiator is preferably an onium salt from the viewpoint of achieving the balance between the sensitivity and raw storage stability. A sulfonium salt is particularly preferable.

Onium salts represented by the following formula (I) are preferable as the sulfonium salt polymerization initiator.

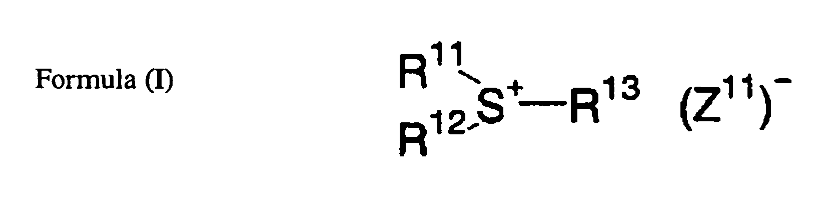

In formula (I), R¹¹, R¹² and R¹³ each independently represent a hydrocarbon group having 20 or less carbon atoms which may have a substituent. The substituent is preferably a halogen atom, a nitro group, an alkyl having 12 or less carbon atoms, an alkoxy group having 12 or less carbon atoms, or an aryloxy group having 12 or less carbon atoms. (Z¹¹)⁻ represents a counter-ion selected from a halogen ion, a perchlorate ion, a tetrafluoroborate ion, a hexafluorophosphate ion, a carboxylate ion, and a sulfonate ion. The counter-ion represented by (Z¹¹)⁻ is preferably a perchlorate ion, a hexafluorophosphate ion, a carboxylate ion, or an arylsulfonate ion.

In the following, examples ([OS-1] to [OS-12]) of the onium salt represented by formula (I) are shown. However, the onium salt represented by formula (I) is not limited to the examples.

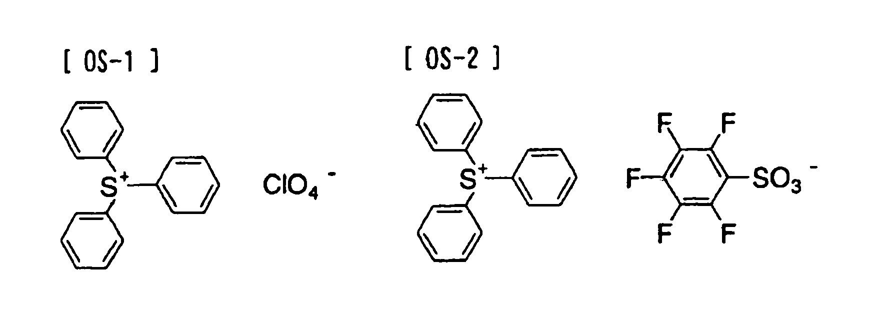

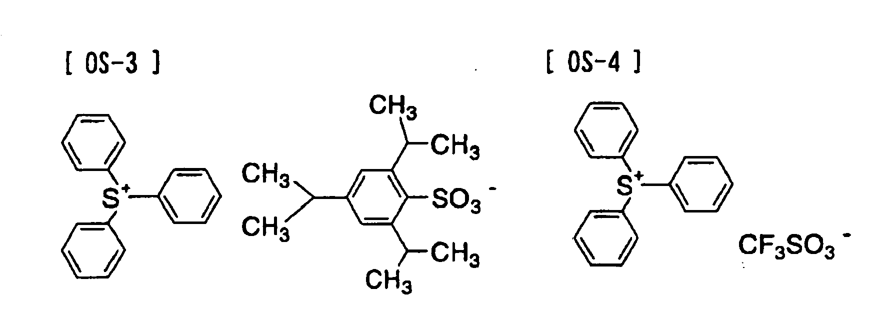

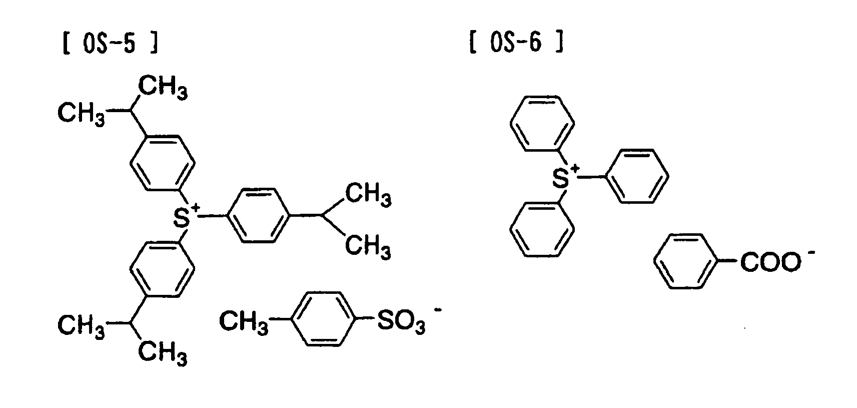

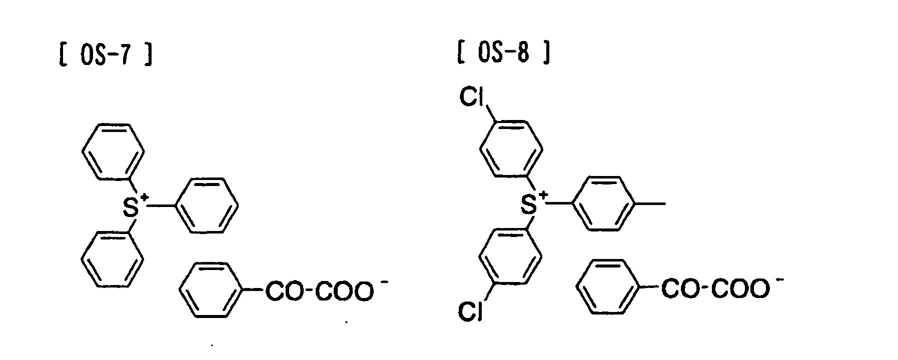

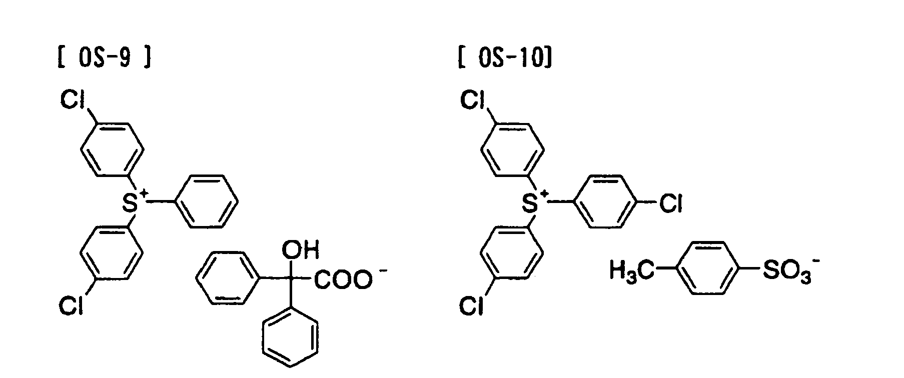

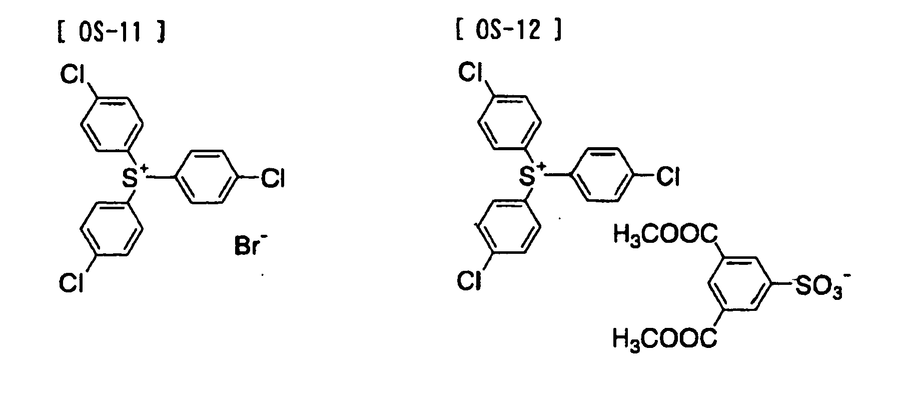

In addition to the examples shown above, specific aromatic sulfonium salts disclosed in the following patent applications are also usable: JP-A Nos. 2002-148790, 2002-148790, 2002-350207, and 2002-6482, the disclosures of which are incorporated herein by reference.

By using the highly sensitive sulfonium salt as the radical polymerization initiator in the negative recording layer of the planographic printing plate precursor, the radical polymerization proceeds efficiently to enable formation of very strong image regions. The high oxygen blocking property of the overcoat layer described layer further improves the strength of the image regions. Such a planographic printing plate having strong image regions have improved printing durability. Further, since the sulfonium salt as the polymerization initiator is stable over time, undesirable polymerization reaction is efficiently prevented when the obtained planographic printing plate precursor is stored.

The radical polymerization initiator used in the invention is not limited to the sulfonium salts, and other known polymerization initiators (other known radical generators) may be selected arbitrarily and used.

Examples of such other radical generators include: onium salts other than sulfonium salts, triazine compounds having trihalomethyl groups, peroxides, azo-based polymerization initiators, azide compounds, quinone diazide, active halogen compounds, oxime ester compounds, and triaryl monoalkyl borate compounds. Among them, onium salts are preferable because of their high sensitivity. In an embodiment, a combination of the sulfonium salt and another polymerization initiator (radical generator) such as described above is used as the polymerization initiator.

Other examples of the onium salt usable in the invention include iodonium salts and diazonium salts. In the invention, these onium salts act as initiators of the radical polymerization rather than as acid generators.

Examples of the onium salts other than the sulfonium salts include onium salts represented by the following formulae **(II)** and **(III).**

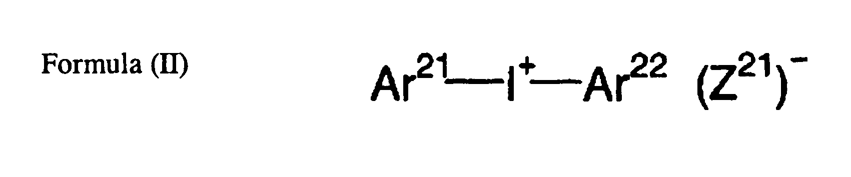

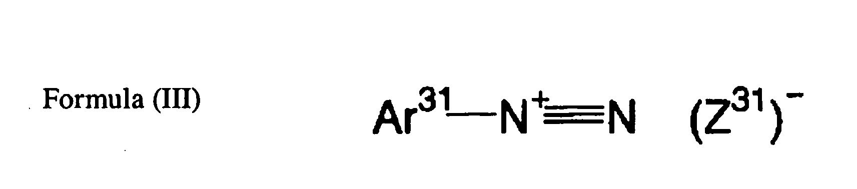

In the formula (II), Ar²¹ and Ar²² each independently represent an aryl group having 20 or less carbon atoms, which may have a substituent, and the substituent is preferably selected from a halogen atom, a nitro group, an alkyl group having 12 carbon atoms less, an alkoxy group having 12 carbon atoms or less, or an aryloxy group having 12 carbon atoms or less. Z²¹⁻ represents a counter-ion whose definition is the same as that of (Z¹¹)⁻ in the above formula (I).

In the formula (III), Ar³¹ represents an aryl group having 20 carbon atoms or less which may have a substituent. The substituent is preferably selected from a halogen atom, a nitro group, an alkyl group having 12 carbon atoms or less, an alkoxy group having 12 carbon atoms or less, an aryloxy group having 12 carbon atoms or less, an alkylamino group having 12 carbon atoms or less, a dialkylamino group having 12 carbon atoms or less, an arylamino group having 12 carbon atoms or less, or a diarylamino group having 12 carbon atoms or less. Z³¹⁻ represents a counter-ion whose definition is the same as that of (Z¹¹)⁻ in the above formula (I).

Preferable examples ([OI-1] to [OI-10]) of the onium salt represented by formula (II) and preferable examples ([ON-1] to [ON-5]) of the onium salt represented by formula (III) are shown below. However, onium salts usable in the invention are not limited to the examples.

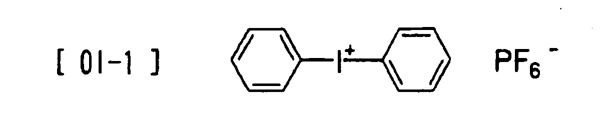

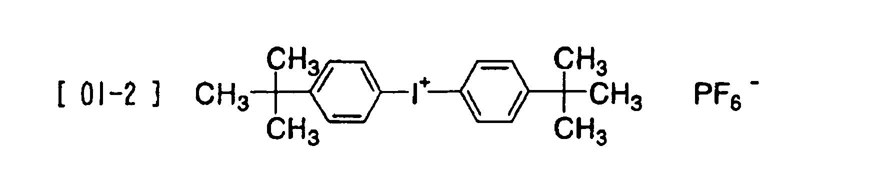

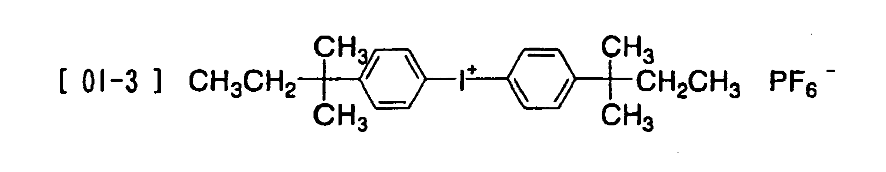

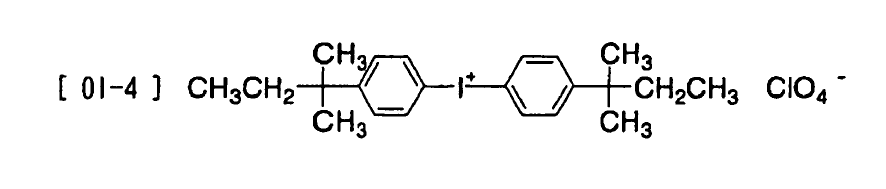

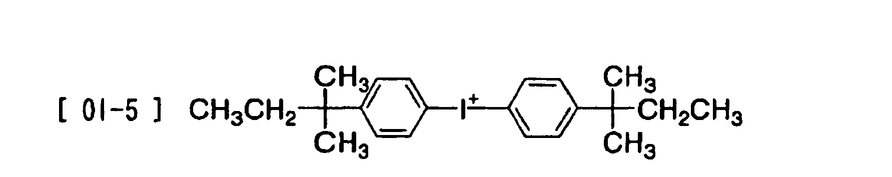

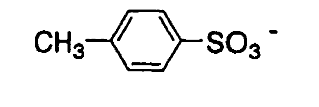

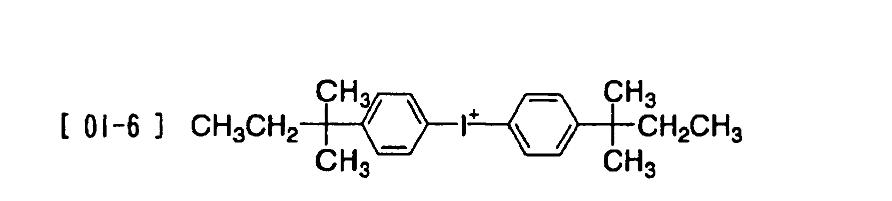

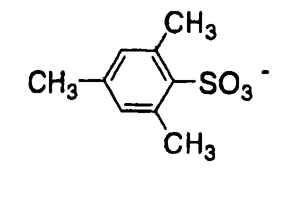

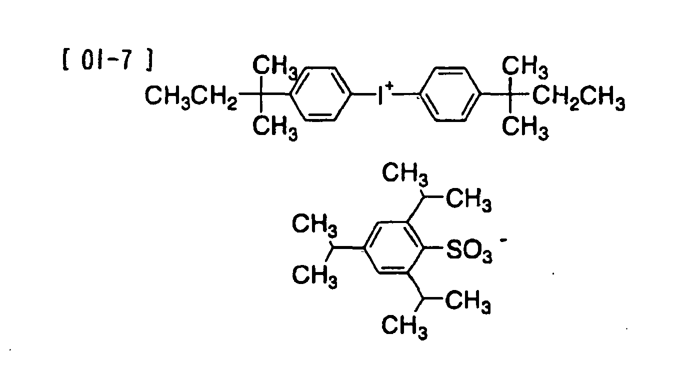

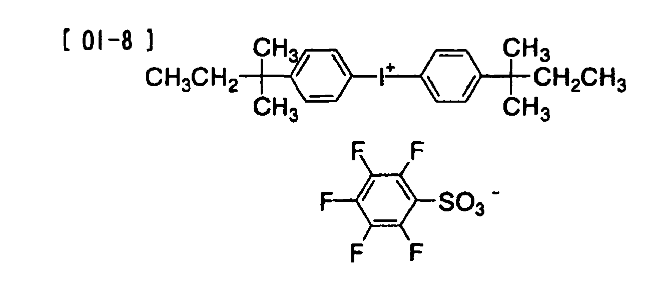

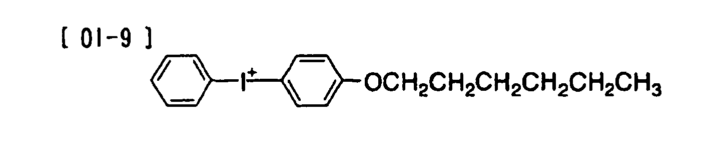

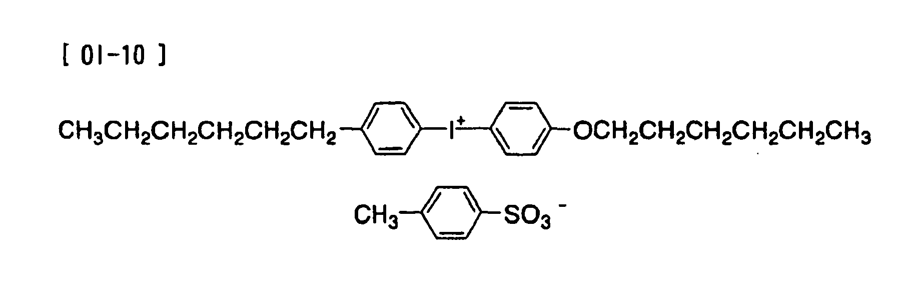

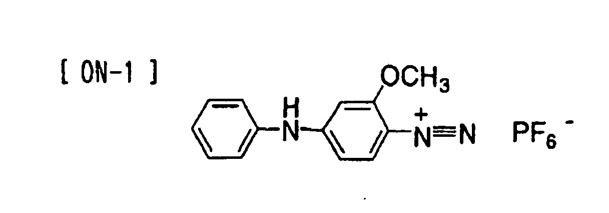

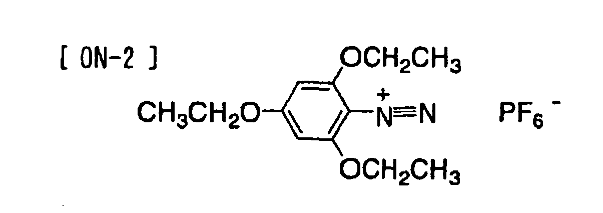

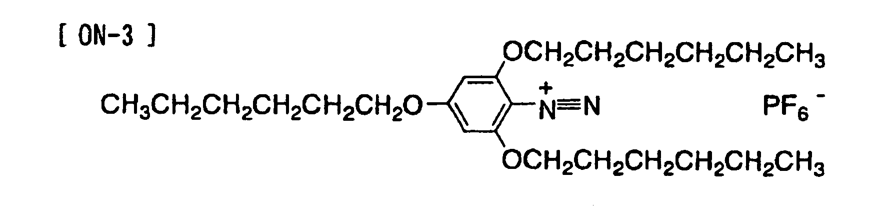

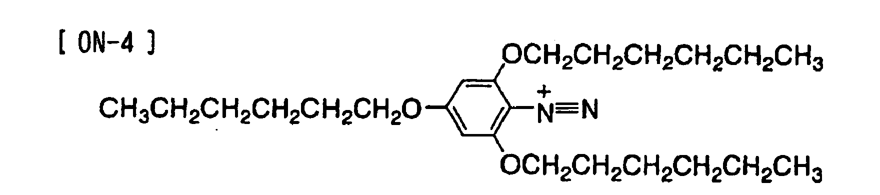

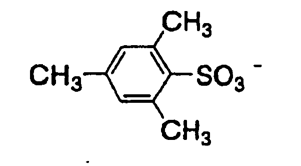

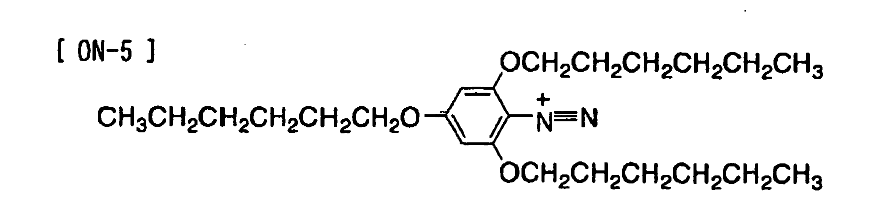

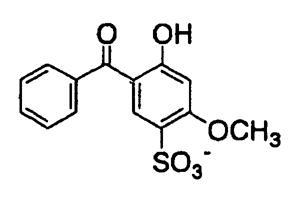

Onium salts disclosed in JP-A No. 2001-133696 (the disclosure of which is incorporated herein by reference) are also usable as the radical polymerization initiators (radical generators) in the invention.

The radical polymerization initiator (radical generator) used in the invention has an absorption peak preferably in the wavelength range of 400 nm or shorter, more preferably in the wavelength range of 360 nm or shorter. When the absorption wavelength is in the ultraviolet range as described above, the planographic printing plate precursor can be handled under white light.

In the invention, only a single radical polymerization initiator may be used, or two or more radical polymerization initiators may be used in combination. When two or more radical polymerization initiators are used, a plurality of sulfonium salt polymerization initiators only may be used, or a sulfonium salt polymerization initiator and a polymerization initiator of another type may be used together.

The content ratio (by mass) of sulfonium salt polymerization initiator to polymerization initiators of other types may be in the range of 100/1 to 100/50, more preferably in the range of 100/5 to 100/25.

The total content of radical polymerization initiator may be, based on the total solid of the negative recording layer, 0.1 to 50 % by mass, preferably 0.5 to 30 % by mass, more preferably 1 to 20 % by mass, from the viewpoints of sensitivity and prevention of stains in non-image regions at printing.

The radical polymerization initiator may be contained in the layer which contains other components of the recording layer, or may be contained in a sub-layer which is different from the sub-layer containing other components of the recording layer.

### (C) Radical-Polymerizable Compound

The radical-polymerizable compound used in the negative recording layer is a radical-polymerizable compound having at least one ethylenic unsaturated double bond, and is selected from compounds having at least one (preferably two or more) terminal ethylenic unsaturated bond. Such compounds are known widely in the related industrial field, and in the invention, the polymerizable compound is selected from these compounds without any particular limitation. The polymerizable compound may be in the chemical form of a monomer, a prepolymer (a dimer, a trimer, an oligomer, or the like), a mixture thereof, or a copolymer thereof.

Examples of the monomer and copolymer include unsaturated carboxylic acids (e.g., acrylic acid, methacrylic acid, itaconic acid, crotonic acid, isocrotonic acid, and maleic acid), esters thereof, and amides thereof. The polymerizable monomer is preferably: an ester between an unsaturated carboxylic acid and an aliphatic polyhydric alcohol; an amide between an unsaturated carboxylic acid and an aliphatic polyvalent amine; an addition-reaction product of an unsaturated carboxylic ester or amide having a nucleophilic substituent such as a hydroxyl group, an amino group, or a mercapto group, with a monofunctional or multifunctional isocyanate or with an epoxy compound; a dehydration condensation reaction product of an unsaturated carboxylic ester or amide having a nucleophilic substituent such as a hydroxyl group, an amino group, or a mercapto group, with a monofunctional or multifunctional carboxylic acid; an addition-reaction product of an unsaturated carboxylic ester or amide having an electrophilic substituent such as an isocyanate group or an epoxy group, with a monofunctional or multifunctional alcohol, amine or thiol; or a substitution-reaction product of an unsaturated carboxylic ester or amide having a dissociative substituent such as a halogen group or a tosyloxy group, with a monofunctional or multifunctional alcohol, amines or thiol. In the above examples, the unsaturated carboxylic acid may be replaced by an unsaturated phosphonic acid, styrene, or the like.

The ester (monomer) between an aliphatic polyhydric alcohol and an unsaturated carboxylic acid may be an acrylic ester, a methacrylic ester, an itaconic ester, a crotonic ester, an isocrotonic ester, or a maleic ester, which is a radical-polymerizable compound. Examples thereof are disclosed in paragraphs [0037] to [0042] of JP-A No. 2001-133969, the disclosure of which is incorporated herein by reference. Such examples may be used in the present invention.

The radical-polymerizable compound may be an ester other than the esters described above. Examples of such an ester include aliphatic alcohol-based esters described in JP-B Nos. 46-27926 and 51-47334 and JP-A No. 57-196231, esters having aromatic skeletons described in JP-A Nos. 59-5240, 59-5241 and 2-226149, and esters having amino groups described in JP-A No. 1-165613. The disclosures of the above patent documents are incorporated herein by reference.

Examples of the amide monomer between an aliphatic polyvalent amine compound and an unsaturated carboxylic acid include methylene bis-acrylamide, methylene bis-methacrylamide, 1,6-hexamethylene bis-acrylamide, 1,6-hexamethylene bis-inethacrylamide, diethylene triamine trisacrylamide, xylylene bisacrylamide, and xylylene bismethacrylamide.

Preferable examples of other amide-type monomers include the amide-type monomers having cyclohexylene structures described in JP-B No. 54-21726, the disclosure of which is incorporated by reference herein.

The polymerizable compound may be a urethane-based addition-polymerizable compound produced by addition reaction between an isocyanate and a hydroxyl group. The urethane addition-polymerizable compound may be a vinyl urethane compound having two or more polymerizable vinyl groups disclosed in JP-B No. 48-41708, the disclosure of which is incorporated by reference herein. The vinyl urethane compound can be prepared by allowing a vinyl monomer having a hydroxyl group represented by the following formula (1) and a polyisocyanate having two or more isocyanate groups to undergo an addition reaction, as described in JP-B No. 48-41708, the disclosure of which is incorporated by reference herein.

CH₂=C(R²¹)COOCH₂CH(R²²)OH Formula (1)

wherein R²¹ and R²² each independently represent H or CH₃.

The polymerizable compound may be selected from the urethane acrylates described in JP-A No. 51-37193 and JP-B Nos. 2-32293 and 2-16765 and the urethane compounds having ethylene-oxide-type skeletons described in JP-B Nos. 58-49860, 56-17654, 62 39417 and 62-39418. Radical-polymerizable compounds having an amino structure or sulfide structure described in JP-A Nos. 63-277653, 63-260909 and 1-105238 are also usable. The disclosures of the above patent documents are incorporated herein by reference.

Examples of the radical-polymerizable compound further include: multifunctional acrylates and methacrylates such as polyester acrylates disclosed in JP-A No. 48-64183 and JP-B Nos. 49-43191 and 52-30490 and epoxy acrylates obtained by allowing epoxy resins to react with (meth)acrylic acid; specific unsaturated compounds disclosed in JP-B Nos. 46-43946, 1-40337 and 1-40336; vinyl phosphonic acid compounds disclosed in JP-A No. 2-25493; a structure containing a perfluoroalkyl group disclosed in JP-A No. 61-22048; and photosetting monomers and oligomers disclosed in the Journal of Japanese Adhesive Society, vol. 20, No. 7, pp. 300-308 (1984). The disclosures of the above patent documents and journal are incorporated herein by reference.

Details (such as the structure, amount, and whether used alone or in combination with another radical-polymerizable compounds) of the method for using the radical-polymerizable compound may be arbitrary determined in accordance with the design of the performance of the final image recording material. For example, the radical-polymerizable compound may be selected from the following viewpoints. In respect of the sensitivity, the radical-polymerizable compound preferably has a structure containing many unsaturated groups in one molecule; in many cases, the radical-polymerizable compound preferably has bi-or higher-functionality. To increase the strength of the image region (cured layer), the radical-polymerizable compound preferably has tri-or higher-functionality. It is also effective to control both the sensitivity and the strength by using a combination of radical-polymerizable compounds (e.g. acrylates, methacrylates, and styrene compounds) having different functionalities and/or different polymerizable groups.

While a radical-polymerizable compound having a high molecular weight and a highly hydrophobic radical-polymerizable compound have superior sensitivity and provide excellent film strength, they are not preferable in respect of the developing speed and precipitation in the developer. The selection and manner of use of the radical-polymerizable compound is an important factor for compatibility with other components (e.g. a binder polymer, an initiator, and a colorant) in the negative recording layer and dispersibility in the negative recording layer. The compatibility may be improved, for example by using a radical-polymerizable compound with low purity or a combined use of two or more radical-polymerizable compounds.

A specific structure may be selected for the purpose of improving the adhesion of the negative recording layer to a support, an overcoat layer, or the like. A higher content of radical-polymerizable compound in the image recording layer is preferable in respect of sensitivity. However, excessively high content may lead to problems of undesirable phase separation, troubles in the production process caused by adhesion of the image recording layer (such as transfer of the image recording layer component and production of defective products owing to the adhesion), and precipitation out of the developer.

In consideration of these factors, the radical-polymerizable compound is used preferably in the range of 5 to 80% by weight, more preferably 20 to 75 % by weight, based on the total weight of the components constituting the image recording layer. Only a single radical-polymerizable compound may be used, or two or more radical-polymerizable compounds may be used. When the radical-polymerizable compound is used, the structure, amount, addition manner of the radical-polymerizable compound may be selected arbitrary, considering the degree of polymerization inhibition by oxygen, the resolution, the fogging property, the change in refraction index, and the surface adhesiveness of the image recording layer. An undercoat layer may be provided under the image recording layer and an overcoat layer may be provided on the image recording layer.

### (D) Binder Polymer

The negative recording layer of the invention preferably includes a binder polymer from the viewpoint of improvement of the film property. The binder polymer may be selected from various binder polymers having a function of improving the film property, such as acrylic binders, styrene binders, butyral binders, and urethane binders. The after-described binder polymers each having an ethylenic unsaturated double bond and/or an alkali-soluble group are preferable.

Such binder polymers may be obtained by using a copolymerization component having an ethylenic unsaturated double bond and an alkali-soluble group, or by using two or more binders each having an ethylenic unsaturated double bond or an alkali-soluble group. It is preferable to use a binder polymer containing a structural unit having an ethylenic unsaturated double bond and an alkali-soluble group as a copolymerization component.

### (Group Having Ethylenic Unsaturated Double Bond)

The group having an ethylenic unsaturated double bond is not particularly limited and may be selected from groups capable of polymerizing in the presence of a radical. The group having an ethylenic unsaturated double bond may be, for example, an α-substituted methylacryl group (-OC(=O)-C(-CH₂Z)=CH₂, wherein Z represents a hydrocarbon group having a heteroatom bonded to the remaining structure other than Z), an acryl group, a methacryl group, an allyl group, or a styryl group. An acryl group and a methacryl group are preferable.

The content of the ethylenic unsaturated double bond (the content of the radical-polymerizable unsaturated double bond measured by iodometry) in the binder polymer is preferably 0.1 to 10.0 mmnol per 1 g of binder polymer, more preferably 1.0 to 7.0 mmol per 1 g of binder polymer, still more preferably 2.0 to 5.5 mmol per 1 g of binder polymer, from the viewpoint of achieving a balance between the sensitivity and the storability.

### (Alkali-Soluble Group)

The alkali-soluble group in the binder polymer is preferably selected from the following groups (1) to (6) from the viewpoint of solubility of the binder polymer in an alkaline developer. A binder polymer containing a structure unit containing at least one alkali-soluble group selected from the groups (1) to (6) is preferable.
(1) Phenolic hydroxyl groups (-Ar-OH)
(2) Sulfonamide groups (-SO₂NH-R)
(3) Substituted sulfonamide groups (occasionally referred to as "active imide groups" hereinafter) (-SO₂NHCOR, -SO₂NHSO₂R, -CONHSO₂R)
(4) Carboxylic acid groups (-CO₂H)
(5) Sulfonic acid groups (-SO₃H)
(6) Phosphoric acid groups (-OPO₃H₂)

In the above groups (1) to (6), Ar represents a divalent aryl connecting group which may have a substituent, and R represents a hydrogen atom or a hydrocarbon group which may have a substituent.

In an embodiment, the binder polymer is formed of only one type of structural having an alkali-soluble group (an acidic group) selected from the groups (1) to (6). In another embodiment, the binder polymer is formed of two or more types of structural units having the same acidic group selected from the groups (1) to (6). In another embodiment, the binder polymer is formed of two or more types of structural units having different acid groups selected from the groups (1) to (6).

The content of alkali-soluble group (acid value measured by neutralization titration) in the binder polymer is preferably 0.1 to 3.0 mmol per 1 g of binder polymer, more preferably 0.2 to 2.0 mmol per 1 g of binder polymer, still more preferably 0.45 to 1.0 mmol per 1 g of binder polymer, from the viewpoints of printing durability and prevention of generation of development debris.

The structural unit having an alkali-soluble group may be a structural unit represented by the following formula (i).

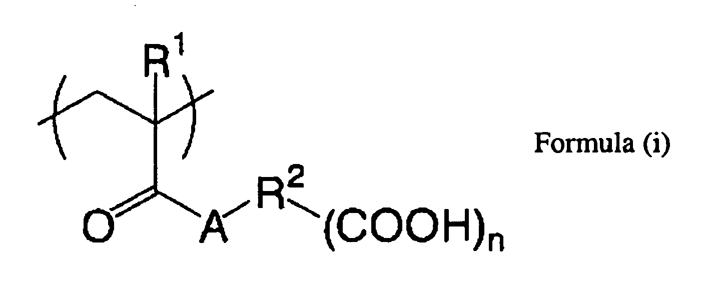

In formula (i), R¹ represents a hydrogen atom or a methyl group; R² represents a connecting group which includes two or more atoms selected from carbon atoms, hydrogen atoms, oxygen atoms, nitrogen atoms and sulfur atoms and which has 2 to 82 atoms in total; A represents an oxygen atom or -NR³-; R³ represents a hydrogen atom or a monovalent hydrocarbon group having 1 to 10 carbon atoms; and n represents an integer of 1 to 5.

R¹ in formula (i) represents a hydrogen atom or a methyl group, preferably a methyl group.

The connecting group represented by R² in formula (i) contains two or more atoms selected from carbon atoms, hydrogen atoms, oxygen atoms, nitrogen atoms, and sulfur atoms. The connecting group has 2 to 82 atoms in total, preferably has 2 to 50 atoms in total, more preferably has 2 to 30 atoms in total. When the connecting group has a substituent, the total number of atoms covers the number of atoms of the substituent(s). More specifically, the number of atoms of the main skeleton of the connecting group represented by R² is preferably 1 to 30, more prefereably 3 to 25, still more preferably 4 to 20; most preferably 5 to 10. The term "main skeleton of the connecting group" refers to an atom or an atomic group participating in connection of "A" and the terminal COOH group in formula (i). In particular, when the connecting group provides a plurality of connecting routes, the main skeleton of the connecting group refers to an atom or an atomic group participating in the shortest connection between "A" and the terminal COOH group. Accordingly, when the connecting group includes a cyclic structure therein, the number of the atoms to be counted may vary depending on the connecting position (e.g., ortho, meta, or para).

Specific examples of the connecting group include a substituted alkylene, an unsubstituted alkylene, a substituted arylene, an unsubstituted arylene, and a group obtained by connecting a plurality of such bivalent groups via amide bond(s) or ester bond(s).

Examples of connecting group having a chain structure include ethylene and propylene. Connecting groups obtained by connecting such alkylene groups via ester bond(s) are also preferable.

The connecting group represented by R² in formula (i) is preferably a hydrocarbon group having an alicyclic structure with 3 to 30 carbon atoms and a valence of (n+1). Specific examples of the connecting group include hydrocarbon groups having a valence of (n+1) obtained by removing (n+1) hydrogen atoms bonded to arbitrary carbon atoms in an alicyclic hydrocarbon compound such as cyclopropane, cyclopentane, cyclohexane, cycloheptane, cyclooctane, cyclodecane, dicyclohexyl, tercyclohexyl, and norbornane, which each may have one or more substituents. R² preferably has 3 to 30 carbon atoms including the carbon atoms of the substituents.

One or more arbitrarily selected carbon atoms of the aliphatic cyclic structure may optionally be substituted by at least one hetero atom selected from nitrogen atoms, oxygen atoms and sulfur atoms. In view of printing durability, R² is preferably a hydrocarbon group with a valence of (n+1) having an aliphatic cyclic structure which may have a substituent having 5 to 30 carbon atoms, the hydrocarbon group containing two or more rings, such as a condensed polycyclic aliphatic hydrocarbon, an aliphatic hydrocarbon containing crosslinked rings, a spiro aliphatic hydrocarbon or a combination of aliphatic hydrocarbon rings connected to each other via a bond or connecting group. The carbon number mentioned above is also determined by taking the number of carbon atoms in the substituent into account.

The connecting group represented by R² is particularly preferably a group whose main skeleton has 5 to 10 carbon atoms. The shape of the connecting group is preferably a chain structure having an ester bond therein or a cyclic structure such as described above.

Examples of the substituent which may be introduced into the connecting group represented by R² include monovalent nonmetal atomic groups excluding hydrogen, such as halogen atoms (-F, -Br, -Cl and -I), a hydroxyl group, alkoxy groups, aryloxy groups, a mercapto group, alkylthio groups, arylthio groups, alkyldithio groups, aryldithio groups, an amino group, N-alkylamino groups, N,N-dialkylamino groups, N-arylamino groups, N,N-diarylamino groups, N-alkyl-N-arylaminogroups, acyloxy group, a carbamoyloxy group, N-alkylcarbamoyloxy groups, N-arylcarbamoyloxy groups, N,N-dialkylcarbamoyloxy groups, N,N-diarylcarbamoyloxy groups, N-alkyl-N-arylcarbamoyloxy groups, alkylsulfoxy groups, arylsulfoxy groups, acylthio groups, acylamino groups, N-alkylacylamino groups, N-arylacylamino groups, an ureido group, N'-alkylureido groups, N',N'-dialkylureido groups, N'-arylureido groups, N',N'-diarylureido groups, N'-alkyl-N'-arylureido groups, N-alkylureido groups, N-arylureido groups, N'-alkyl-N-alkylureido groups, N'-alkyl-N-arylureido groups, N',N'-dialkyl-N-alkylureido groups, N',N'-dialkyl-N-arylureido groups, N'-aryl-N-alkylureido groups, N'-aryl-N-arylureido groups, N',N'-diaryl-N-alkylureido groups, N',N'-diaryl-N-arylureido groups, N'-alkyl-N'-aryl-N-alkylureido groups, N'-alkyl-N'-aryl-N-arylureido groups, alkoxycarbonylamino groups, aryloxycarbonylamino groups, N-alkyl-N-alkoxycarbonylamino groups, N-alkyl-N-aryloxycarbonylamino groups, N-aryl-N-alkoxycarbonylamino groups, N-aryl-N-aryloxycarbonylamino groups, a formyl group, acyl groups, a carboxyl group and conjugated base groups thereof, alkoxycarbonyl groups, aryloxycarbonyl groups, a carbamoyl group, N-alkylcarbamoyl groups, N,N-dialkylcarbamoyl groups, N-arylcarbamoyl groups, N,N-diarylcarbamoyl groups, N-alkyl-N-arylcarbamoyl groups, alkylsulfinyl groups, arylsulfinyl groups, alkylsulfonyl groups, arylsulfonyl groups, a sulfo group (-SO₃H) and conjugated base groups thereof, alkoxysulfonyl groups, aryloxysulfonyl groups, a sulfinamoyl group, N-alkylsulfinamoyl groups, N,N-dialkylsulfinamoyl groups, N-arylsulfinamoyl groups, N,N-diarylsulfinamoyl groups, N-alkyl-N-arylsulfinamoyl groups, a sulfamoyl group, N-alkylsulfamoyl groups, N,N-dialkylsulfamoyl groups, N-arylsulfamoyl groups, N,N-diarylsulfamoyl groups, N-alkyl-N-arylsulfamoyl groups, N-acylsulfamoyl groups and conjugated base groups thereof, N-alkylsulfonylsulfamoyl groups (-SO₂NHSO₂(alkyl)) and conjugated base groups thereof, N-arylsulfonylsulfamoyl groups (-SO₂NHSO₂(aryl)) and conjugated base groups thereof, N-alkylsulfonylcarbamoyl groups (-CONHSO₂(alkyl)) and conjugated base groups thereof, N-arylsulfonylcarbamoyl groups (-CONHSO₂(aryl)) and conjugated base groups thereof, alkoxysilyl groups (-Si(Oalkyl)₃), aryloxysilyl groups (-Si(Oaryl)₃), a hydroxysilyl group (-Si(OH)₃) and conjugated base groups thereof, a phosphono group (-PO₃H₂) and conjugated base groups thereof, dialkylphosphono groups (-PO₃(alkyl)₂), diarylphosphono groups (-PO₃(aryl)₂), alkylarylphosphono groups (-PO)₃(alkyl)(aryl)), monoalkylphosphono groups (-PO₃H(alkyl)) and conjugated base groups thereof, monoarylphosphono groups (-PO₃H(aryl)) and conjugated base groups thereof, a phosphonooxy group (-OPO₃H₂) and conjugated base groups thereof, dialkylphosphonoxy groups (-OPO₃(alkyl)₂), diarylphosphonoxy groups (-OPO₃(aryl)₂), alkylarylphosphonoxy groups (-OPO₃(alkyl)(aryl)), monoalkylphosphonoxy groups (-OPO₃H(alkyl)) and conjugated base groups thereof, monoarylphosphonoxy groups (-OPO₃H(aryl)) and conjugated base groups thereof, a cyano group, a nitro group, dialkylboryl groups (-B(alkyl)₂), diarylboryl groups (-B(aryl)₂), alkylarylboryl groups (-B(alkyl)(aryl)), a dihydroxyboryl group (-B(OH)₂) and conjugated base groups thereof, alkylhydroxyboryl groups (-B(alkyl)(OH)) and conjugated base groups thereof, arylhydroxyboryl groups (-B(aryl)(OH)) and conjugated base groups thereof, aryl groups, alkenyl groups, and alkynyl groups.

In the planographic printing plate precursor of the invention, substituents having a hydrogen atom capable of forming a hydrogen bond, (particularly, substituents having smaller acid dissociation constants (pKa) than carboxylic acid) are not preferred because they may reduce the printing durability, depending on the design of the negative recording layer. On the contrary, halogen atoms and hydrophobic substituents such as hydrocarbon groups (e.g., alkyl groups, aryl groups, alkenyl groups and alkynyl groups), alkoxy groups and aryloxy groups are preferable because they tend to improve the printing durability. In particular, when the cyclic structure is a monocyclic aliphatic hydrocarbon whose ring skeleton has 6 or less atoms, such as cyclopentane or cyclohexane, the cyclic structure preferably has a hydrophobic substituent such as described above. If possible, a ring may be formed by formation of bond between substituent or formation of an additional bond between a substituent and the hydrocarbon group having the substituent thereon. The substituent itself may have a substituent.

When A in formula (i) is NR³-, R³ represents a hydrogen atom or a monovalent hydrocarbon group having 1 to 10 carbon atoms. The monovalent hydrocarbon group having 1 to 10 carbon atoms represented by R³ may be, for example, an alkyl group, an aryl group, an alkenyl group, or an alkynyl group.

The alkyl group represented by R³ may be a linear, branched, or cyclic alkyl group having 1 to 10 carbon atoms. Examples thereof include a methyl group, an ethyl group, a propyl group, a butyl group, a pentyl group, a hexyl group, a heptyl group, an octyl group, a nonyl group, a decyl group, an iso-propyl group, an iso-butyl group, a sec-butyl group, a tert-butyl group, an iso-pentyl group, a neopentyl group, a 1-methylbutyl group, an iso-hexyl group, a 2-ethylhexyl group, a 2-methylhexyl group, a cyclopentyl group, a cyclohexyl group, a 1-adamantyl group, and a 2-norbornyl group.

The aryl group represented by R³ may be, for example: an aryl group having 1 to 10 carbon atoms such as a phenyl group, a naphthyl group, or an indenyl group; or a hetero aryl group having 1 to 10 carbon atoms containing one hetero atom selected from a nitrogen atom, an oxygen atom and a sulfur atom, such as a furyl group, a thienyl group, a pyrrolyl group, a pyridyl group, or a quinolyl group.

The alkenyl group represented by R³ may be a linear, branched, or cyclic alkenyl group having 1 to 10 carbon atoms, such as a vinyl group, a 1-propenyl group, a 1-butenyl group, a 1-methyl-1-propenyl group, a 1-cyclopentenyl group, and a 1-cyclohexenyl group.

The alkynyl group represented by R³ may be an alkynyl group having 1 to 10 carbon atoms, such as an ethynyl group, a 1-propynyl group, a 1-butynyl group, or a 1-octynyl group.

The group represented by R³ may have a substituent whose examples are the same as the above-described examples of the substituent on the group represented by R². The number of carbon atoms in R³ is 1 to 10, taking the number of carbons in the substituent into account.

In formula (i), A is preferably an oxygen or -NH in consideration of the easiness of the synthesis. In formula (i), n represents an integer of 1 to 5, preferably 1 from the viewpoint of printing durability.

Preferable examples of the repeating unit represented by formula (i) are shown below. However, the repeating unit is not limited to the examples.

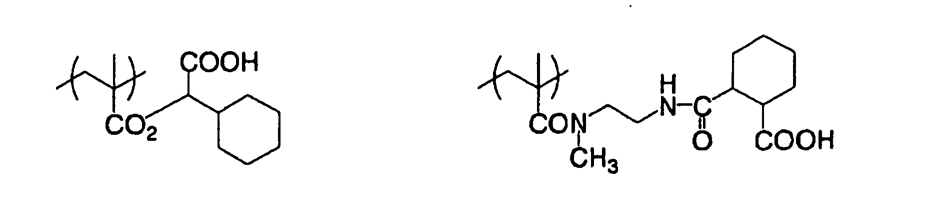

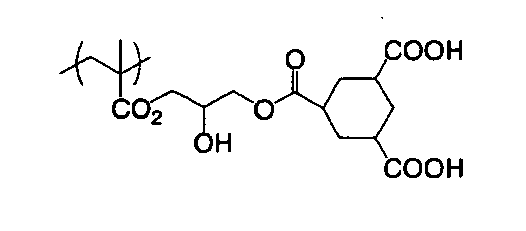

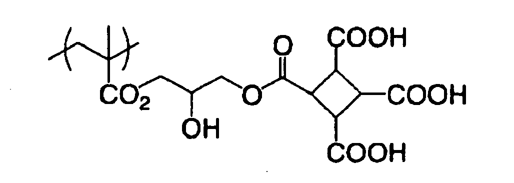

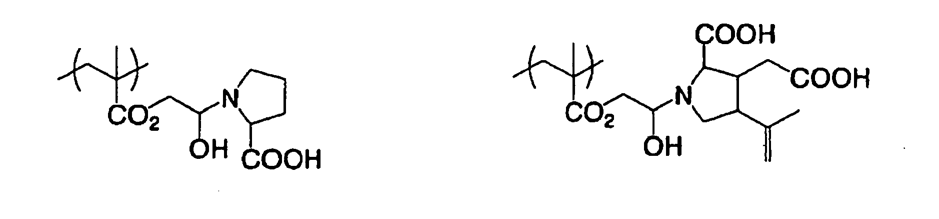

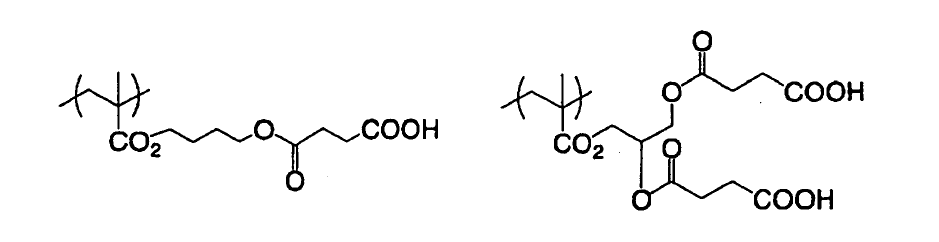

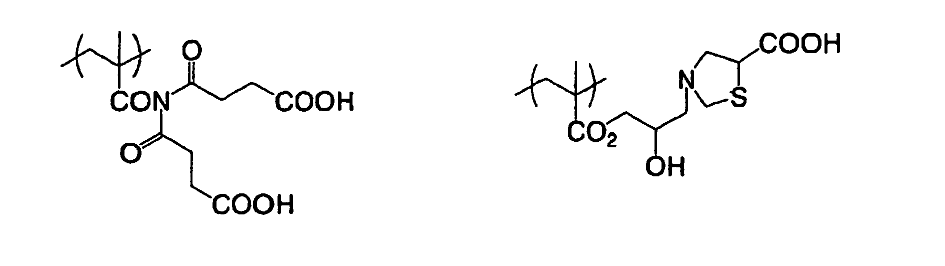

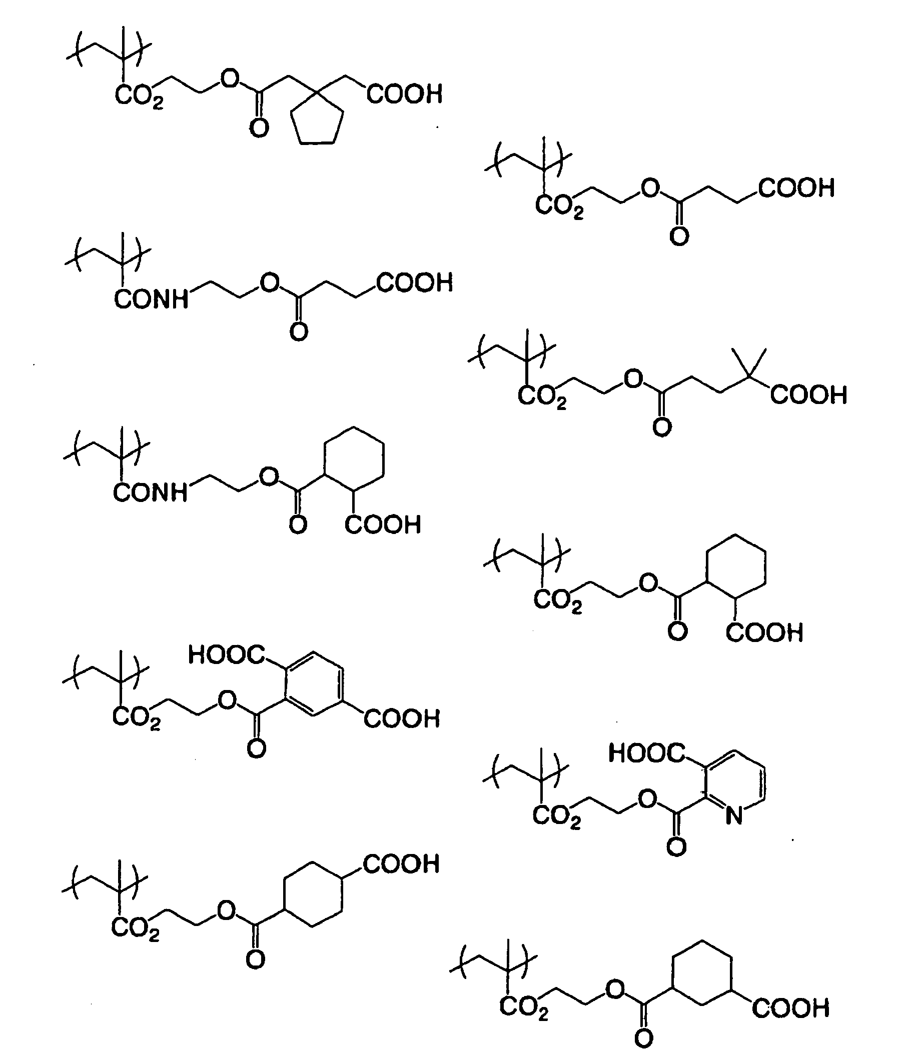

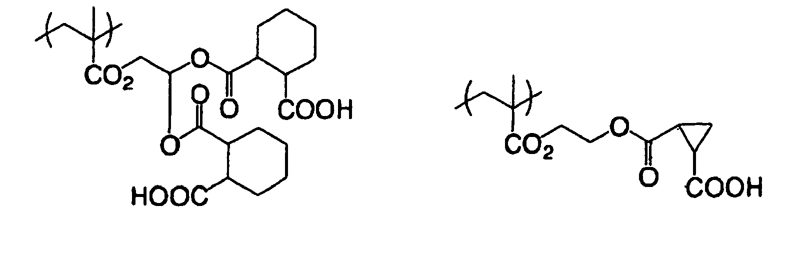

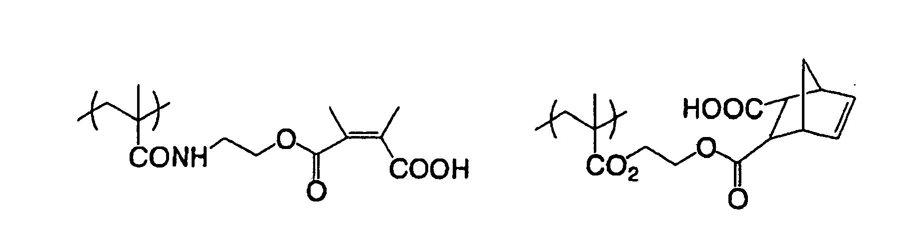

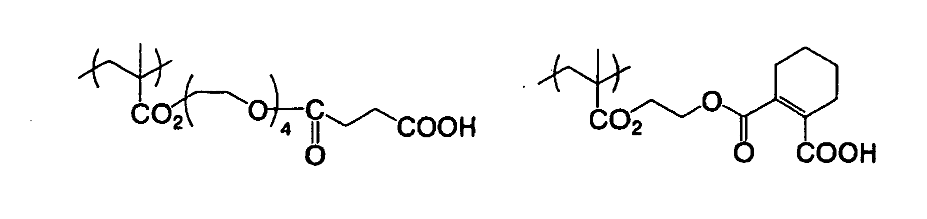

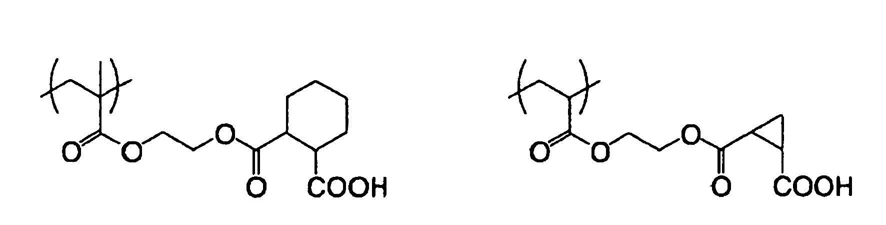

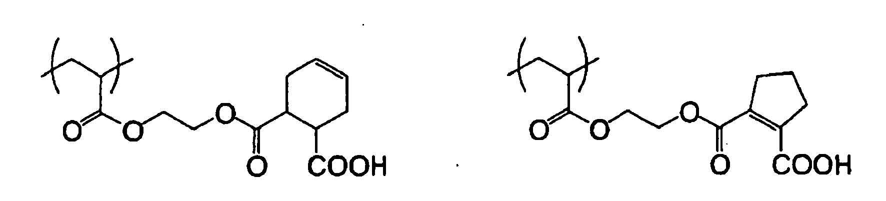

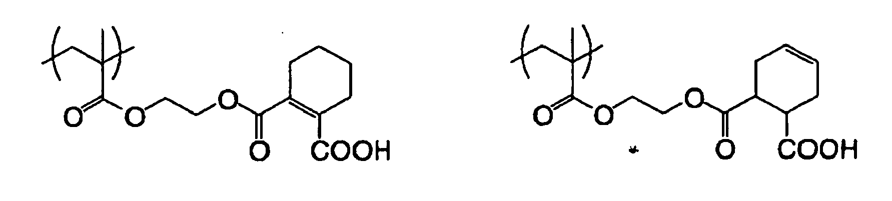

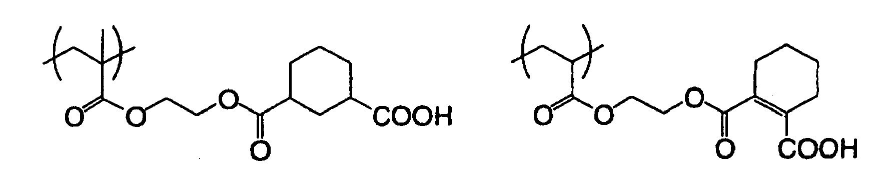

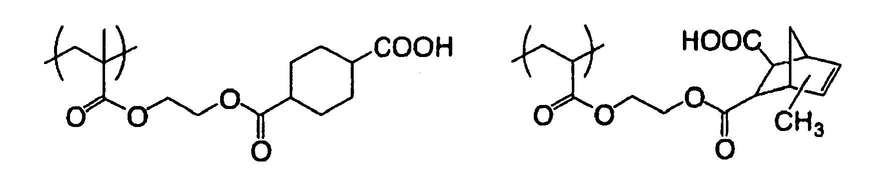

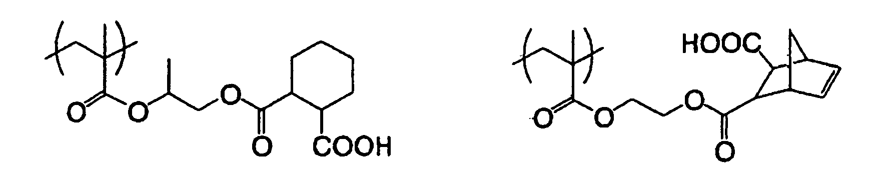

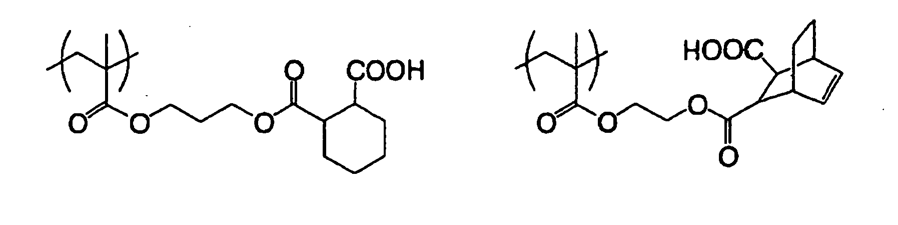

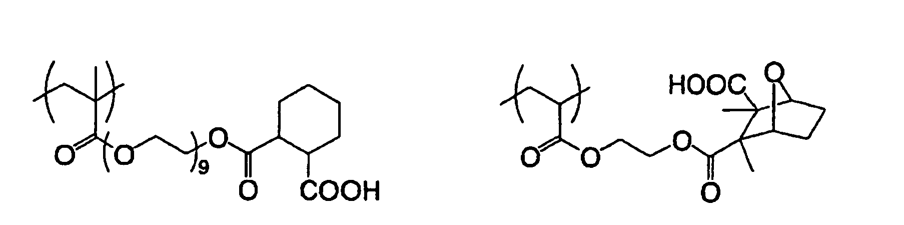

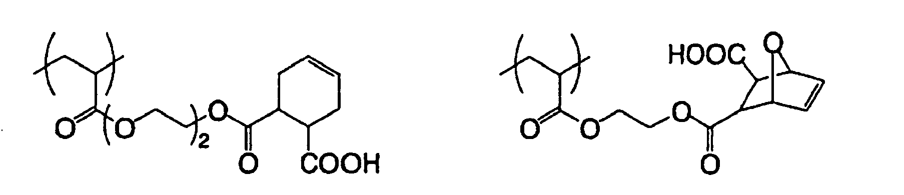

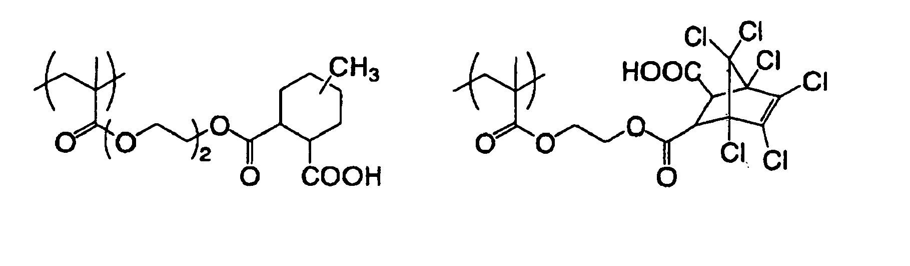

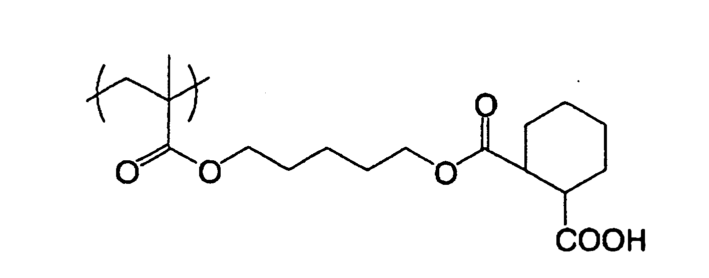

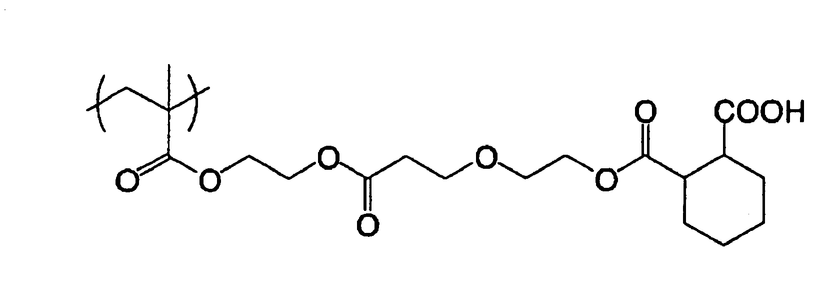

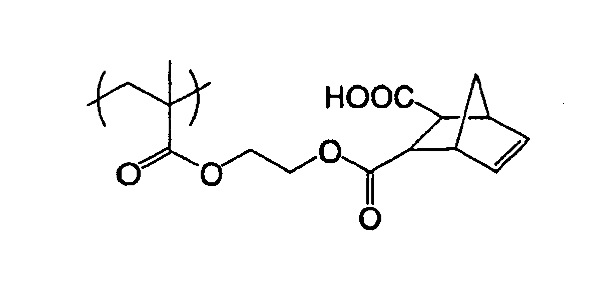

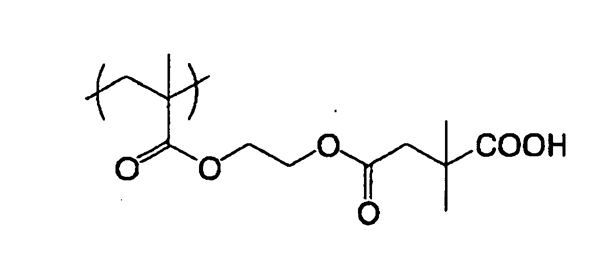

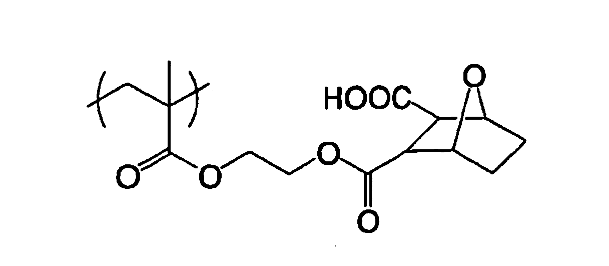

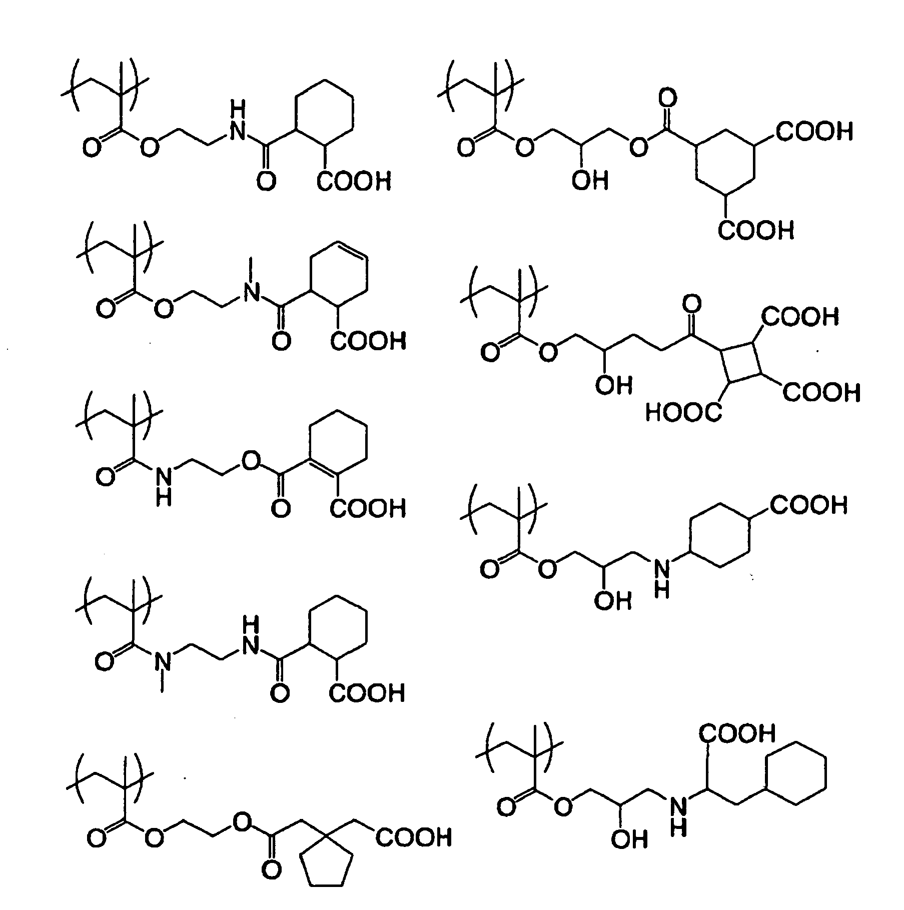

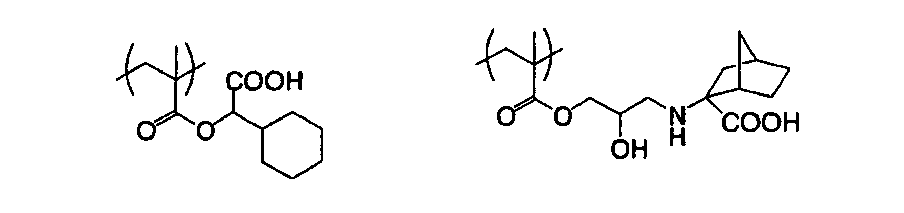

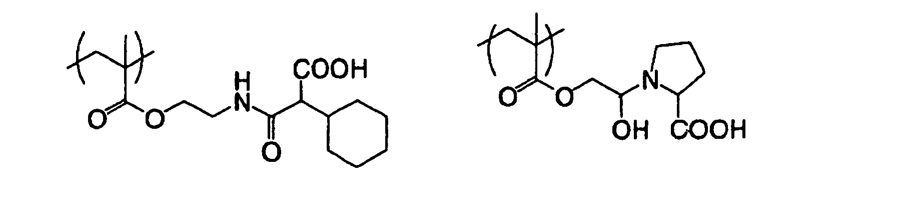

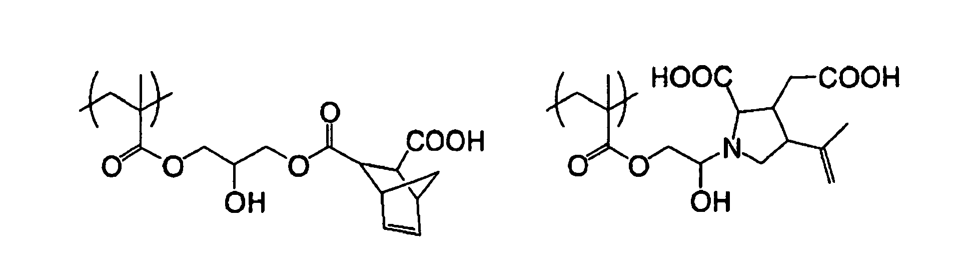

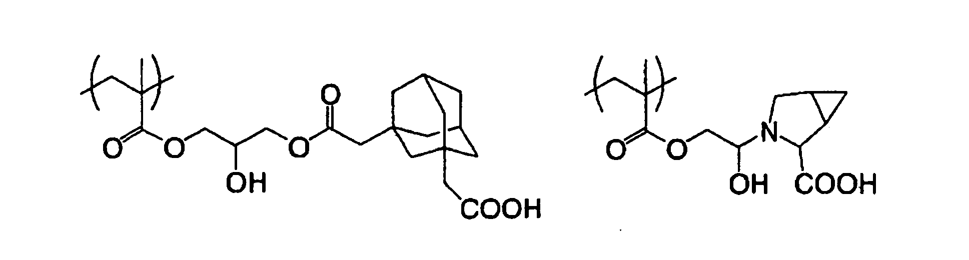

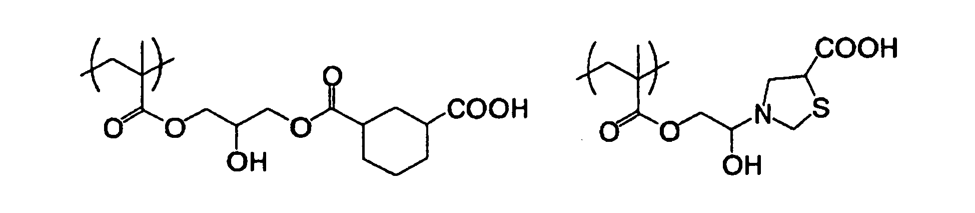

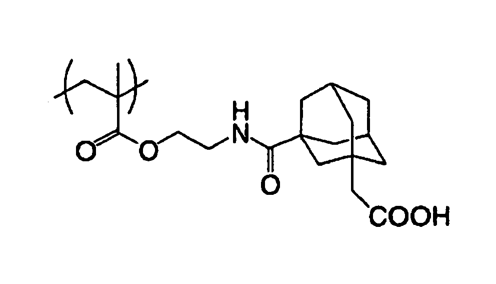

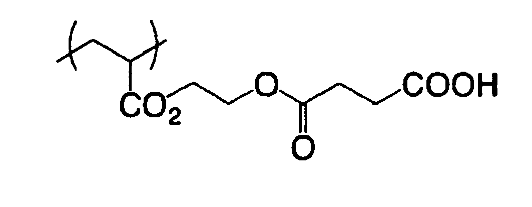

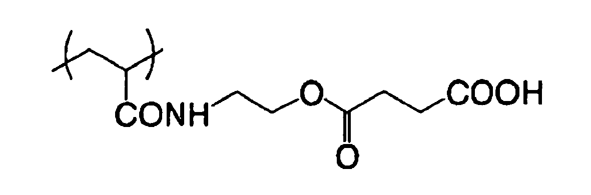

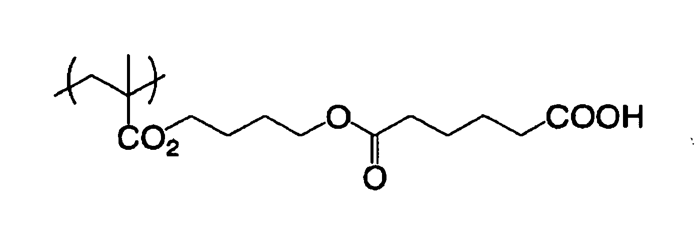

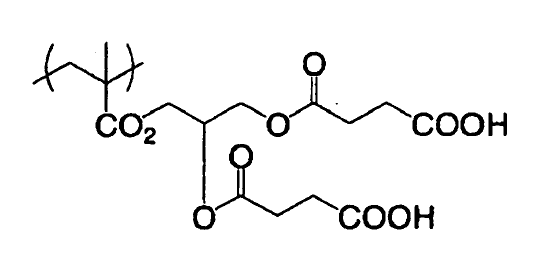

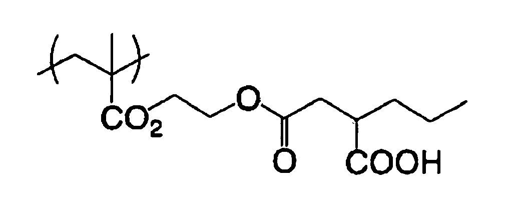

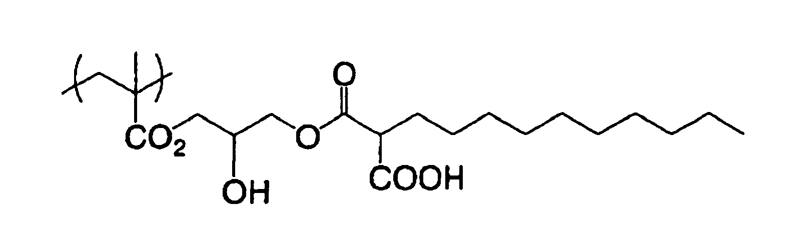

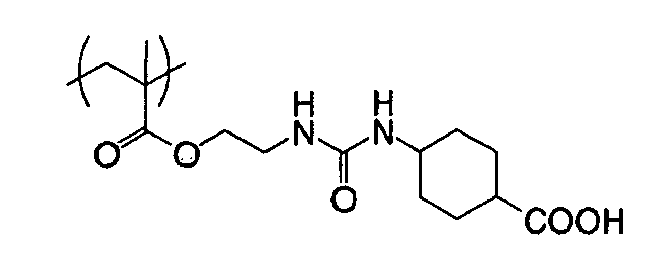

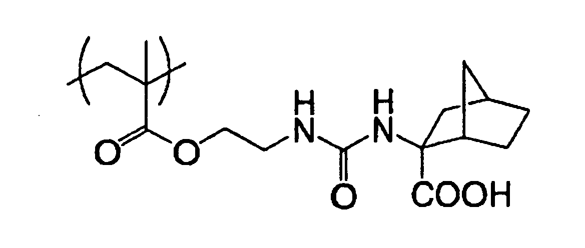

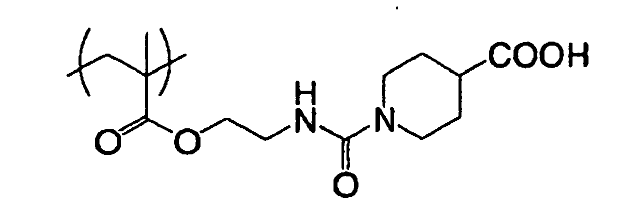

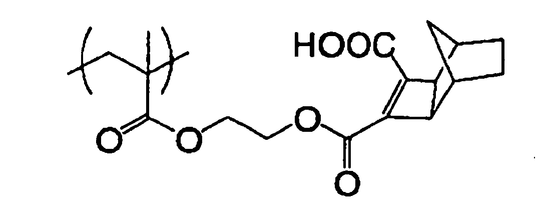

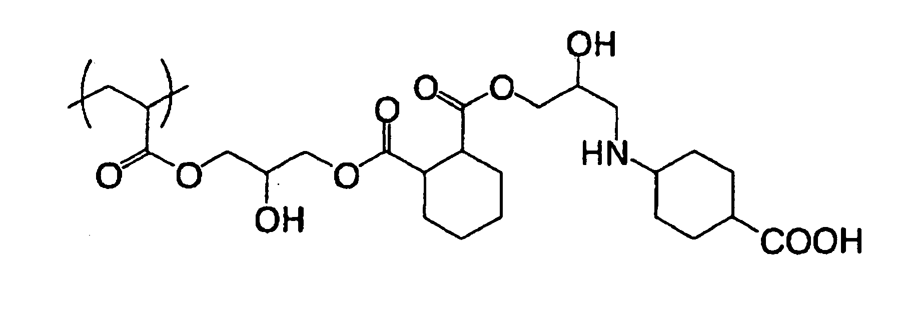

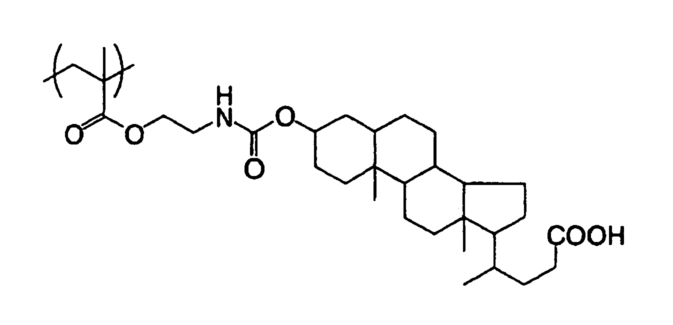

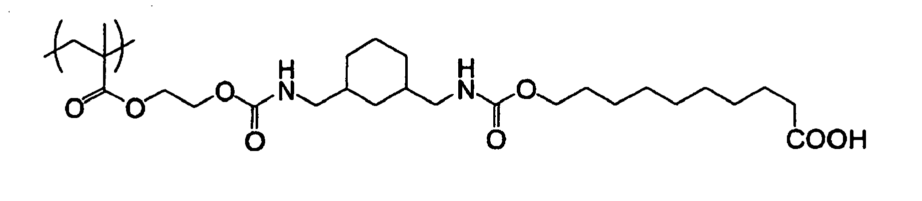

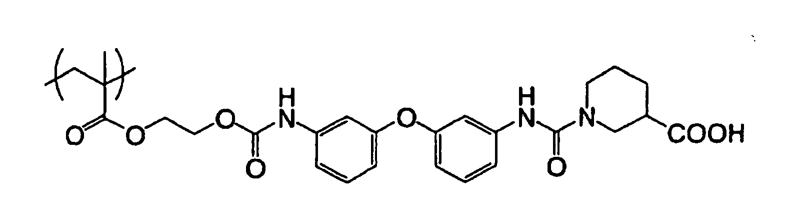

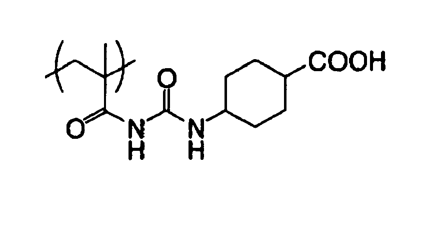

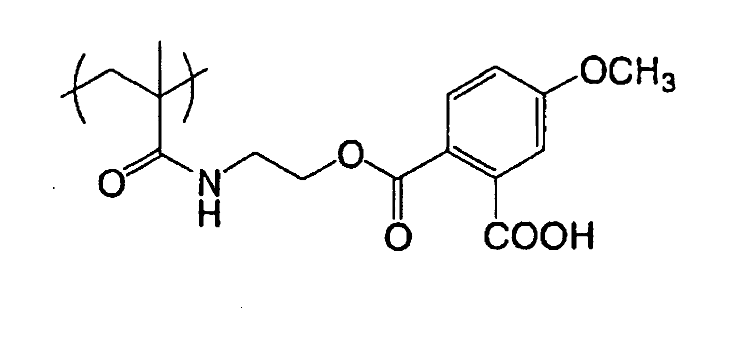

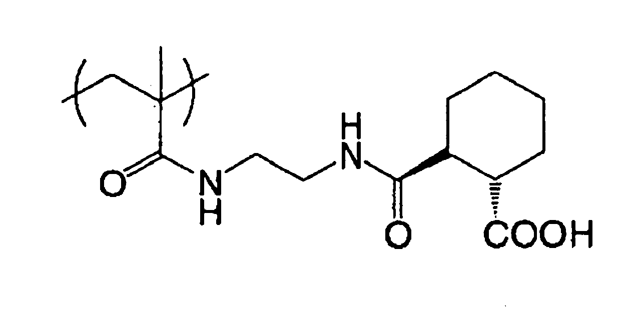

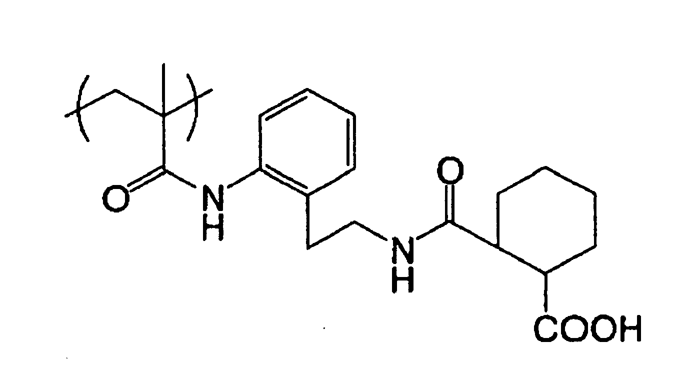

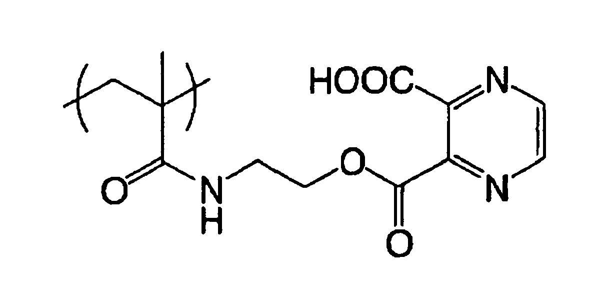

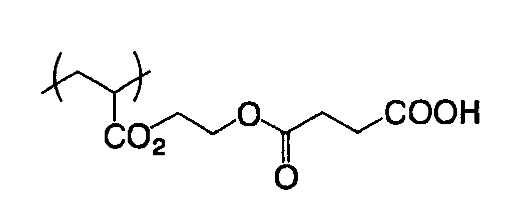

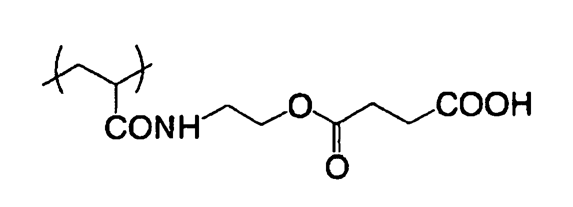

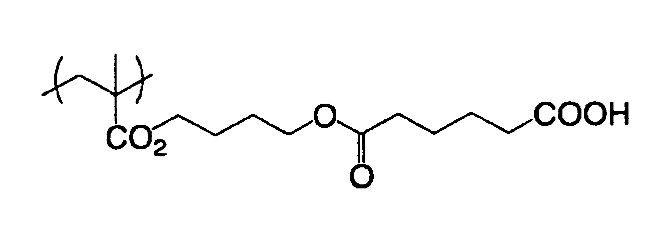

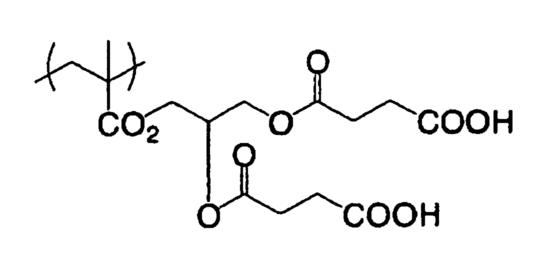

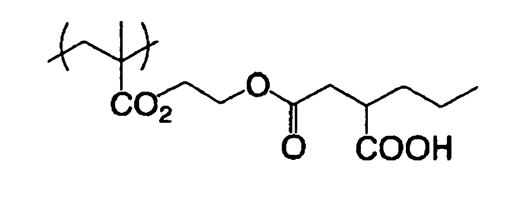

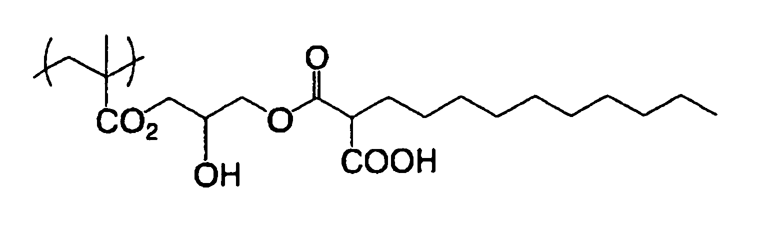

There may be only one repeating unit represented by formula (i) in the binder polymer, or there may be two or more repeating units represented by formula (i) in the binder polymer. The specific binder polymer used in the invention may be a polymer consisting of the repeating unit represented by formula (i), but is usually a copolymer containing the repeating unit represented by formula (i) and a repeating unit other than the repeating unit represented by formula (i). The total content of the repeating unit represented by formula (i) in the copolymer is suitably determined based on the design of the copolymer structure, the design of the negative recording layer composition, and the like. The total content of the repeating unit represented by formula (i) in the copolymer is preferably in the range of 1 to 99 % by mol, more preferably 5 to 40 % by mol, still more preferably 5 to 20 % by mol with respect to the total mol number of the polymer components.

When the binder polymer is a copolymer, the copolymerization component to be used may be any conventionally known monomer, insofar as it is a radical-polymerizable monomer. The copolymerization component may be selected, for example from monomers described in "Kobunshi Data Handbook" (Polymer Data Handbook) "Kiso-hen" (Fundamental Step) edited by Kobunshi Gakkai (Society of Polymer Science, Japan), published by BAIFUKAN CO., LTD in 1986, the disclosure of which is incorporated herein by reference. Only one copolymerization component may be used, or two or more copolymerization components may be used.

The binder polymer may comprise only the specific polymer containing the repeating unit represented by formula (i), or may comprise a mixture of the specific polymer and at least one polymer other than the specific polymer. In an embodiment, the binder polymer comprises one or more known binder polymer(s) other than the specific polymer but does not comprise the specific polymer. When the specific polymer containing the repeating unit represented by formula (i) and a known binder polymer other than the specific polymer are used together, the binder polymer other than the specific polymer is used in an amount of preferably 1 to 60 % by mass based on the total weight of the entire binder polymer, more preferably 1 to 40 % by mass, still more preferably 1 to 20 % by mass.

The binder polymer other than the specific polymer may be selected from conventionally known binder polymers without particular restrictions. The known binder polymer may be, for example, a binder polymer whose main chain is an acrylic chain, a urethane binder, or a binder whose main chain is a styrene chain.

Also in the above case, the total content of ethylenic unsaturated double bond per 1 g of binder polymer (the entire binder polymer) is preferably within the above-mentioned range. Specifically, the total content of ethylenic unsaturated double bond per 1 g of binder polymer is preferably 0.1 to 10.0 mmol, more preferably 1.0 to 7.0 mmol, still more preferably 2.0 to 5.5 mmol.

The total acid value per 1 g of binder polymer (the entire binder polymer) is preferably 0.45 to 3.6 mmol.

The weight-average molecular weight of the binder polymer used in the invention is preferably in the range of 2,000 to 1,000,000, more preferably in the range of 10,000 to 300,000, still more preferably in the range of 20,000 to 200,000, from the viewpoints of film forming property (printing durability) and solubility in the solvent for coating.

The glass transition point (Tg) of the binder polymer is preferably 70 to 300 °C, more preferably 80 to 250 °C, still more preferably 90 to 200 °C, from the viewpoints of storage stability, printing durability, and sensitivity.

The glass transition point of the binder polymer can be heightened by incorporating an amide or imide group into the binder polymer. In a preferable embodiment, the binder polymer includes methacryl amide or a methacryl amide derivative.

The total content of the binder polymer in the negative recording layer composition may be adequately determined, and is usually in a range of 10 to 90 % by mass based on the total mass of the nonvolatile components in the recording layer composition, preferably 20 to 80 % by mass, still more preferably 30 to 70 % by mass.

### Other Components

In the invention, in addition to the compounds described above, the negative recording layer may further comprise various compounds in accordance with the necessity. For example, a dye having a large absorption in the visible-ray range may be used as a coloring agent for the image. Pigments such as phthalocyanine pigments, azo pigments, carbon black, and titanium oxide are also usable.

It is preferable to add such a coloring agent since the coloring agent makes it easier to distinguish image regions from non-image regions after image formation. The amount of the coloring agent to be added may be 0.01 to 10 % by mass based on the total solid of the negative recording layer.

It is preferable to add a small amount of a heat-polymerization inhibitor to the negative recording layer of the invention in order to inhibit undesired heat polymerization of the compound having a radical-polymerizable unsaturated double bond during preparation or storage of the coating liquid. Preferable examples of the heat-polymerization inhibitor include hydroquinone, p-methoxyphenol, di-t-butyl-p-cresol, pyrogallol, t-butyl catechol, benzoquinone, 4,4'-thiobis(3-methyl-6-t-butyl phenol), 2,2'-methylene bis(4-methyl-6-t-butyl phenol), and N-nitroso-N-phenyl hydroxylamine aluminum salt. The amount of the heat-polymerization inhibitor to be added is preferably about 0.01 to about 5% by mass relative to the total mass of the composition.

In order to prevent the polymerization inhibition by oxygen, a higher fatty acid derivative such as behenic acid or behenic amide may be added such that the higher fatty acid derivative is present on the surface of the negative recording layer in the drying process after coating. The amount of the higher fatty acid derivative to be added is preferably about 0.1 % by mass to about 10% by mass relative to the total weight of the composition.

In order to improve processing stability to variety of development conditions, a nonionic or amphoteric surfactant may be added to the negative recording layer. The nonionic surfactant may be selected, for example from nonionic surfactants disclosed in JP-A Nos. 62-251740 and 3-208514, the disclosures of which are incorporated herein by reference. The amphoteric surfactant may be selected, for example from amphoteric surfactants disclosed in JP-A Nos. 59-121044 and 4-13149, the disclosures of which are incorporated herein by reference.

Examples of the nonionic surfactant include sorbitan triacetate, sorbitan monopalmitate, sorbitan triolate, stearic acid monoglyceride, and polyoxyethylene nonyl phenyl ether.

Examples of the amphoteric surfactant include alkyldi(aminoethyl)glycine, alkylpolyaminoethylglycine hydrochloride, 2-alkyl-N-carboxyethyl-N-hydroxyethylimidazolinium betaine, and N-tctradecyl-N,N-betaine type (such as AMORGEN K manufactured by Daiichi Kogyo Co., Ltd.)

The content of nonionic surfactant and amphoteric surfactant in the negative recording layer composition is preferably 0.05 to 15 % by mass, more preferably 0.1 to 5 % by mass.

A plasticizer may be added as necessary to the negative recording layer composition (coating liquid for the negative recording layer) in order to impart flexibility to the coating layer. For example, the plasticizer may be polyethylene glycol, tributyl citrate, diethyl phthalate, dibutyl phthalate, dihexyl phthalate, dioctyl phthalate, tricresyl phosphate, tributyl phosphate, trioctyl phosphate, or tetrahydrofurfuryl oleate.

### Method of Producing Planographic Printing Plate Precursor

The planographic printing plate precursor of the invention can be prepared by a process comprising dissolving the components described above in a solvent to form a coating liquid, and coating the support with the coating liquid to form a negative recording layer.

The solvent may be, for example, ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, N,N-dimethylacetamide, N,N-dimethylformamide, tetramethyl urea, N-methyl pyrrolidone, dimethyl sulfoxide, sulfolane, y-butyrolactone, toluene or water. Only a single solvent may be used or a mixture of two or more solvents may be used. The content of the above components (the total solid content including additives) in the solvent is preferably 1 to -50% by mass.

The amount (in terms of the solid amount) of the image recording layer, which was formed on the support by coating and drying, may be changed in accordance with the intended use, and is preferably 0.5 to 5.0 g/m² in general in the case of a planographic printing plate precursor. The coating may be conducted by any of various methods whose examples include bar-coater coating, spin coating, spray coating, curtain coating, dip coating, air knife coating, blade coating and roll coating. A smaller coating amount increases the apparent sensitivity, but deteriorates the film property of the negative recording layer having image recording function.

### Overcoat Layer

In the invention, it is preferable to provide an overcoat layer on the negative recording layer containing a radical-polymerizable compound. In the invention, the negative recording layer is subjected to exposure usually in the air, and the overcoat layer prevents the incorporation of low-molecular compounds in the air (such as oxygen and basic substances) into the image recording layer, which low-molecular compounds inhibit the image formation reaction in the image recording layer caused by the exposure. In this manner, the overcoat layer prevents the inhibition of the image formation reaction in the air upon exposure to radiation. Accordingly, the overcoat layer preferably has a low permeability to low-molecular compounds such as oxygen. The overcoat layer preferably has a high transmittance to the radiation used in the exposure. The overcoat layer is preferably capable of adhering tightly to the image recording layer. The overcoat layer is preferably easily removable in the development process after exposure.

The overcoat layer having such properties has been extensively examined and described in detail in US Patent No. 3,458,311 and JP-A 55-49729, the disclosures of which are incorporated by reference herein.

The material used in the overcoat layer is preferably a water-soluble polymer compound having relatively high crystallinity. Specific examples thereof include water-soluble polymers such as polyvinyl alcohol, polyvinyl pyrrolidone, acidic celluloses, gelatin, gum arabic and polyacrylic acid. When polyvinyl alcohol is used as a main component, the overcoat layer is optimal with respect to basic characteristics such as oxygen impermeability and removability upon development. The polyvinyl alcohol may be partially substituted by an ester, an ether or an acetal and may partially include other copolymerizable components insofar as it contains unsubstituted vinyl alcohol units which give the oxygen blocking property and water solubility required for the overcoat layer.

The polyvinyl alcohol may be a polyvinyl alcohol hydrolyzed to a degree of 71 to 100%, having a polymerization degree in the range of 200 to 2400. Specific examples thereof include PVA-102, PVA-103, PVA-104, PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613, L-8, KL-506, and KL-318, all of which are manufactured by Kuraray Co., Ltd.

In a preferable embodiment, the overcoat layer comprises a surfactant so as to control the friction coefficient between the overcoat layer and the back surface of the support. The surfactant may be a nonionic surfactant, an anionic surfactant, or an amphoteric surfactant. Examples of the nonionic surfactant include: polyoxyethylene alkyl ethers such as polyoxyethylene lauryl ether, polyoxyethylene cetyl ether, and polyoxyethylene stearyl ether; polyoxyethylene alkyl aryl ethers such as polyoxyethylene octyl phenyl ether and polyoxyethylene nonyl phenyl ether, polyoxyethylene alkyl esters such as polyoxyethylene stearate; sorbitan alkyl esters such as sorbitan monolaurate, sorbitan monostearate, sorbitan distearate, sorbitan monooleate, sorbitan sesquioleate, and sorbitan trioleate; and monoglyceride alkyl esters such as glycerol monostearate and glycerol monooleate. Examples of the anionic surfactant include: alkylbenzene sulfonic acid salts such as sodium dodecylbenzene sulfonate; alkylnaphthalene sulfonic acid salts such as sodium butylnaphthalene sulfonate, sodium pentylnaphthalene sulfonate, sodium hexylnaphthalene sulfonate, and sodium octylnaphthalene sulfonate; alkyl sulfuric acid salts such as sodium lauryl sulfate; alkyl sulfonic acid salts such as sodium dodecyl sulfonate; and sulfosuccinic acid ester salts such as sodium dilaurylsulfosuccinate. Examples of the amphoteric surfactant include alkyl betaines such as lauryl betaine and stearyl betaine, and amino acids.

Further, the overcoat layer may have other functions. For example, when a coloring agent (for example, a water-soluble dye) which has high transmittance to radiation used for exposure but efficiently absorbs radiations of wavelengths not involved in exposure is added to the overcoat layer, the adaptability to safelight is improved without deteriorating the sensitivity. In the case of a planographic printing plate precursor of the invention, the radiation used for exposure may be, for example, an infrared radiation in the wavelength range of about 760 nm to about 1,200 nm.

### Stack of Planographic Printing Plate Precursor

The stack of planographic printing plate precursors according to the invention comprises a plurality of planographic printing plate precursors of the invention. In the stack, the planographic printing plate precursors are stacked such that the front surface of a planographic printing plate precursor directly contacts the back surface of the next planographic printing plate precursor.

As described above, when the planographic printing plate precursors of the invention are stacked without insertion of inserting paper, each planographic printing plate precursor can be easily peeled off the stack. Accordingly, the stack of planographic printing plate precursors of the invention eliminates the conventional needs for an additional process of alternately overlaying planographic printing plate precursors and sheets of inserting paper, and for materials used in the process.

### Method of Making Planographic Printing Plate from Planographic Printing Plate Precursor

The method of making a planographic printing plate from a planographic printing plate precursor comprises: setting the stack of the planographic printing plate precursors of the invention in a plate setter; conveying the planographic printing plate precursors one by one; and subjecting the respective planographic printing plate precursors to imagewise exposure.

When the stack of the planographic printing plate precursor of the invention is used, operation of removing inserting paper in the plate setter is omitted in a continuous plate making process, whereby the working efficiency is improved. Further, the probability of occurrence of conveyance trouble of the planographic printing plate precursors in the plate setter is lowered. Therefore, the method of making a planographic printing plate of the invention realizes improved plate-making efficiency. Details of the method of making a planographic printing plate from the planographic printing plate precursor are described below.

The planographic printing plate precursor of the invention is usually subjected to imagewise exposure and development.

The radiation source used for the imagewise exposure may be a radiation source emitting radiation of a wavelength which the radiation absorber in the negative recording layer of the planographic printing plate precursor can absorb. Examples of the radiation source used for imagewise exposure include: an active light source such as a mercury lamp, a metal halide lamp, a xenon lamp, a chemical lamp, or carbon arc; and a radiation source such as a radiation source emitting X ray, ion beams, far-infrared rays, i-line rays, or high-density energy beams (laser beams). Examples of usable lasers include a He-Ne laser, an Ar laser, a Kr laser, a He-Cd laser, and a KrF excimer laser. In the invention, a radiation source having an emission wavelength in the near-infrared to infrared region is preferable. A solid laser and a semiconductor laser are more preferable.

The output of the laser is preferably 100 mW or higher. It is preferable to use a multi-beam laser device so as to shorten the exposure time. The exposure time per one pixel is preferably 20 µsec or shorter. The energy of irradiation of the negative recording layer is preferably 10 to 300 mJ/cm².

After imagewise exposure, the planographic printing plate precursor of the invention is preferably developed with water or an alkaline aqueous solution.

In an embodiment, the development treatment is conducted just after irradiation with laser beams. In another embodiment, a heat treatment is conducted between irradiation with laser beams and development. The temperature of the heat treatment is preferably 80 °C to 150 °C, and the heat treatment time is preferably 10 seconds to 5 minutes. When the heat treatment is conducted, the laser energy required for recording can be decreased.

The developer is preferably an alkaline aqueous solution. The alkaline aqueous solution preferably has a pH of 10.0 to 13.5, more preferably 10.5 to 13.0. When the alkaline aqueous solution has a pH of lower than 10.0, non-image regions are easily stained. When the alkaline aqueous solution has a pH of higher than 13.5, the strength of image regions may be lowered.

The alkali aqueous solution for developer and replenisher may be a known alkaline aqueous solution. Examples of the alkaline aqueous solution include: inorganic alkaline salts such as sodium silicate, potassium silicate, sodium tertiary phosphate, potassium tertiary phosphate, ammonium tertiary phosphate, sodium secondary phosphate, potassium secondary phosphate, ammonium secondary phosphate, sodium carbonate, potassium carbonate, ammonium carbonate, sodium hydrogen carbonate, potassium hydrogen carbonate, ammonium hydrogen carbonate, sodium borate, potassium borate, ammonium borate, sodium hydroxide, ammonium hydroxide, potassium hydroxide, and lithium hydroxide; organic alkaline chemicals such as monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine and pyridine.

Only a single alkaline agent may be used, or two or more alkaline agents may be used in combination.

For promoting or suppressing developing performance, for dispersing development residues and for improving the affinity of the image region on the printing plate for ink, various surfactants and organic solvents can be added as necessary to the developer and the replenisher.

The surfactant is added to the developer in the range of preferably 1 to 20% by mass, more preferably 3 to 10% by mass. If the amount of the surfactant added is less than 1% by mass, promotion of development is not sufficient, while if the surfactant is added in an amount of higher than 20% by mass, disadvantages may occur such as reduction in strength e.g. abrasion resistance of images.

Preferable surfactants include anionic, cationic, nonionic and amphoteric surfactants. Examples of the surfactant include: sodium salts of lauryl alcohol sulfate; ammonium salts of lauryl alcohol sulfate; sodium salts of octyl alcohol sulfate; alkyl aryl sulfonates such as sodium isopropyl naphthalene sulfonate, sodium isobutyl naphthalene sulfonate, sodium polyoxyethylene glycol mononaphthyl ether sulfate, sodium dodecyl benzene sulfonate and sodium m-nitrobenzene sulfonate; C₈₋₂₂ higher alcohol sulfates such as sodium secondary alkyl sulfate; fatty alcohol phosphates such as sodium cetyl alcohol phosphate; alkylamide sulfonates such as C₁₇H₃₃CON(CH₃)CH₂CH₂SO₃Na; dibasic aliphatic ester sulfonates such as sodium dioctyl sulfosuccinate and sodium dihexyl sulfosuccinate; ammonium salts such as lauryl trimethyl ammonium chloride and lauryl trimethyl ammonium methosulfate; amine salts such as stearamide ethyl diethyl amine acetate; polyhydric alcohols such as glycerol fatty monoester and pentaerythritol fatty monoester; and polyethylene glycol ethers such as polyethylene glycol mononaphthyl ether and polyethylene glycol mono(nonylphenol)ether.

The organic solvent is preferably an organic solvent having a solubility in water of about 10% by mass or less, more preferably 5% by mass or less. Examples thereof include 1-phenyl ethanol, 2-phenyl ethanol, 3-phenyl propanol, 1,4-phenyl butanol, 2,2-phenyl butanol, 1,2-phenoxy ethanol, 2-benzyloxy ethanol, o-methoxy benzyl alcohol, m-methoxy benzyl alcohol, p-methoxy benzyl alcohol, benzyl alcohol, cyclohexanol, 2-methyl cyclohexanol, 4-methyl cyclohexanol and 3-methyl cyclohexanol. The content of the organic solvent is preferably 1 to 5% by mass relative to the total mass of the developer in use. The amount of the organic solvent is closely related to the amount of the surfactant, and as the amount of the organic solvent is increased, the amount of the surfactant is preferably increased. This is because if the organic solvent is used in a large amount in the presence of only a smaller amount of a surfactant, the organic solvent is not dissolved, thus failing to realize sufficient developability.

The developer and the replenisher may contain additives such as a defoamer and water softener, in accordance with the necessity. Examples of the water softener include: polyphosphates such as Na₂P₂O₇, Na₅P₃O₃, Na₃P₃O₉, Na₂O₄P(NaO₃P)PO₃Na₂, and Calgon (sodium polymetaphosphate); ethylenediaminetetraacetic acid, a potassium salt thereof, and a sodium salt thereof; diethylenetriaminepentaacetic acid, a potassium salt thereof, and a sodium salt thereof; triethylenetetraminehexaacetic acid, a potassium salt thereof, and a sodium salt thereof; hydroxyethylethylenediaminetriacetic acid, a potassium salt thereof, and a sodium salt thereof; nitrilotriacetic acid, a potassium salt thereof, and a sodium salt thereof; 1,2-diaminocyclohexanetetraacetic acid, a potassium salt thereof, and a sodium salt thereof; aminopolycarboxylic acids such as 1,3-diamino 2-propanol tetraacetic acid, a potassium salt thereof, and a sodium salt thereof; 2-phosphonobutanetricarboxylic acid-1,2,4, a potassium salt thereof, and a sodium salt thereof; 2-phosphonobutanonetricarboxylic acid-2,3,4, a potassium salt thereof, and a sodium salt thereof; 1-phosphonoethanetricarboxylic acid-1,2,2, a potassium salt thereof, and a sodium salt thereof; organic phosphonic acids such as 1-hydroxyethane-1,1-diphosphonic acid, a potassium salt thereof, and a sodium salt thereof, and aminotri(methylene phosphonic acid), a potassium salt thereof, and a sodium salt thereof. The optimum amount of the water softener is varied depending on the hardness and amount of the hard water to be used, and is generally 0.01 to 5% by mass, more preferably 0.01 to 0.5% by mass, based on the mass of the developer.

Examples of the developer containing a surfactant, an organic solvent and a reducing agent include a developer composition comprising benzyl alcohol, an anionic surfactant, an alkali agent and water described in JP-A No. 51-77401 (the disclosure of which is incorporated herein by reference), a developer composition comprising benzyl alcohol, an anionic surfactant, and an aqueous solution containing a water-soluble - sulfite described in JP-A No. 53-44202 (the disclosure of which is incorporated herein by reference), and a developer composition comprising an organic solvent having a solubility in water of 10% by mass or less at ordinary temperature, an alkali agent and water described in JP-A No. 55-155355 (the disclosure of which is incorporated herein by reference). These compositions are also usable in the invention.

When the planographic printing plate precursor is developed by an automatic processor, the developer is fatigued depending on processed amount, so processing power may be recovered by addition of a fresh developer or an aqueous solution (a replenisher) with a higher alkali strength than the developer. By the addition, a lot of planographic printing plate precursors can be processed for a long time without exchange of the developer in the developer tank. In this case, the solution is preferably supplemented by a method described in US Patent No. 4,882,246, the disclosure of which is incorporated herein by reference. This method can be applied advantageously in the invention.

The planographic printing plate which developed with the developer and the replenisher described above may be post-treated with washing water, a surfactant-containing rinse liquid, and a desensitizing liquid containing gum arabic or a starch derivative. In the invention, a combination of treatments selected from the above may be conducted.

In the industrial fields of plate-making and printing, automatic processors for printing plates have been widely used in recent years for rationalization and standardization of the operations in plate-making. An automatic processor usually has a developing part, a post-treatment part. The automatic processor has a device which transfers a printing plate precursor, processing solution baths, and a spraying device. While an exposed printing plate precursor is transferred horizontally, pumped-up respective processing solutions is sprayed through spray nozzles to develop the printing plate precursors. These days, a method is known in which a planographic printing plate precursor is processed by being transferred by use of submerged guide rolls while immersed in a processing solution bath filled with a processing solution. Such automatic processing can be carried out while supplementing each processing solution with a replenishing solution, based on processed amount, operation time etc. Further, the replenishing solutions can be automatically fed based on the electrical conductance measured by a sensor.

The so-called "use-once" processing may be employed in which a substantially unused processing solution is used for processing.

The planographic printing plate thus obtained is coated with a desensitizing gum as necessary and then subjected to printing. When a planographic printing plate with higher printing resistance is desired, a baking treatment may be conducted on the planographic printing plate.

When the planographic printing plate is subjected to baking, the planographic printing plate before baking is preferably treated with a surface conditioner such as surface conditioners described in JP-B Nos. 61-2518, 55-28062, JP-A Nos. 62-31859 and 61-159655, the disclosures of which are incorporated herein by reference.

In an example of the baking treatment, a sponge or adsorbent cotton impregnated with the surface conditioner is used for coating the planographic printing plate with the surface conditioner. In another example, the printing plate is dipped in a vat filled with the surface conditioner to be coated with the surface conditioner. In another example, the printing plate is coated with the surface conditioner by an automatic coater. Better results are obtained if the coating amount of the surface conditioner is made uniform by a squeegee or squeeze rollers.

Generally, the coating amount of the surface conditioner is preferably 0.03 to 0.8 g/m² (dry weight).

The planographic printing plate coated with the surface conditioner is dried as necessary and then heated to a high temperature by a baking processor (e.g. a baking processor BP-1300 available from Fuji Photo Film Co., Ltd.). In the baking, the heating temperature and the heating time are varied depending on the type of the components forming the image, but are preferably 180 to 300°C and 1 to 20 minutes, respectively.

After baking treatment, the planographic printing plate may be subjected to conventional treatments such as washing with water and gumming as necessary. When a surface conditioner containing a water-soluble polymer or the like is used, the so-called desensitizing treatment such as gumming can be omitted.

The planographic printing plate obtained through the above process is set in an offset printing machine or the like, and used for making a lot of prints.

### EXAMPLES

In the following, the present invention is described specifically with reference to Examples. However, the Examples should not be construed as limiting the invention.

### Example 1

### Preparation ofAluminum Support

Melt of an alloy according to JIS A 1050 (which is incorporated herein by reference) was cleaned and cast. The alloy contained 99.5 % or more of Al, 0.30 % of Fe, 0.10 % of Si, 0.02 % of Ti, and 0.013 % of Cu. The cleaning was conducted by subjecting the melt to a degassing treatment so as to remove unnecessary gas and then to a treatment with a ceramic tube filter. The casting was conducted according to a DC casting method. The solidified cast product having a thickness of 500 mm was subjected to facing so that the region within 10 mm from the surface was removed. Thereafter, the cast product is subjected to homogenization at 550°C for 10 hours so as to prevent intermetallic compounds from becoming coarse.

Then, the cast product is hot-rolled at 400 °C, and then annealed at 500 °C for 60 seconds in a continuous annealing funnel, and then cold-rolled to give a rolled aluminum plate having a thickness of 0.30 mm. In the rolling, rolls had such a roughness that the aluminum plate after cold rolling had a center line average roughness Ra of 0.1 µm. Thereafter, the aluminum plate was processed by a tension leveler so that the planarity of the aluminum plate was improved.

Thereafter, the aluminum plate was subjected to the following treatments for making a support for a planographic printing plate.

First, the front surface of the aluminum support (on the side on which the negative recording layer is to be provided) was degreased at 50 °C for 30 seconds by using a 10 % aqueous sodium aluminate solution so as to remove the rolling oil, and then the front surface was subjected to neutralization and desmutting with a 30 % aqueous sulfuric acid solution at 50 °C for 30 seconds.

Thereafter, the back surface of the aluminum support was grained by using a 20 % by weight water suspension of 400-mesh pumice stone manufactured by KCM Corporation and rotating nylon (6-10 nylon) brush whose hair had a diameter of 0.30 mm. Then, the back surface was washed well with water.

Thereafter, the front surface of the aluminum support was subjected to electrolytic graining. The electrolytic graining was conducted in an aqueous solution containing 1 % of nitric acid and 0.5 % of aluminum nitrate at 45 °C with alternating electric current having a duty ratio of 1:1 at a current density of 20 A/dm² supplied by an indirect power supplying cell while the aluminum web was conveyed in the aqueous solution, and an anode electric quantity of 240 C/dm² was supplied to the aluminum support. Thereafter, the aluminum support was subjected to etching at 50°C for 30 seconds with a 10 % aqueous sodium aluminate solution, and then to neutralization and desmutting with a 30 % aqueous sulfuric acid solution at 50 °C for 30 seconds.

Further, oxide films were formed on the front and back surfaces of the aluminum support by anodization. In the anodization, the aluminum web was conveyed in a 20 % aqueous sulfuric acid solution having a temperature of 35 °C as an electrolytic solution while supplied with a direct current of 14 A/dm² supplied from an indirect power supplying cell, so that the aluminum web was electrolytically treated. In this way, an anodic oxide film of 2.5 g/m² was formed on the front surface of the aluminum support.

The thickness of the anodic oxide film formed on the back surface of the aluminum support was about 0.2 g/m² in the center region of the support. The thickness of the anodic oxide film formed on the edge of the aluminum support was about 0.5 g/m².

The center line average roughness Ra of the back surface of the aluminum support thus obtained was 0.4 µm while the center line average roughness Ra of the front surface of the aluminum support was 0.5 µm. The Bekk smoothness of the back surface of the aluminum support was measured according to the method described in JIS P8199 (1998) (which is incorporated herein by reference), and was found to be 200 seconds.

### Formation of Negative Recording Layer

Next, a negative recording layer coating liquid described below was prepared and coated on the front surface of the aluminum support, using a wire bar. The coating liquid was dried by a hot-air drying apparatus at 115 °C for 34 seconds. The coating amount after drying was 1.3 g/m².

### <Negative Recording Layer Coating Liquid>

| | |
|---|---|
| Infrared absorber (IR-1) | 0.074 g |
| Radical polymerization initiator (OS-12) | 0.280 g |
| Additive (PM-1) | 0.151 g |
| Polymerizable compound (AM-1) | 1.00 g |
| Binder polymer (BT-1) | 1.00 g |
| Ethyl Violet (C-1) | 0.04 g |

Fluorine-based surfactant (MEGAFAC F-780-F manufactured by Dainippon Ink and Chemicals Incorporated, 30 % by mass solution in methyl isobutyl ketone

| | | |
|---|---|---|
| (MIBK)) | | 0.015 g |
| | Methyl ethyl ketone | 10.4 g |
| | Methanol | 4.83 g |
| | 1-methoxy-2-propanol | 10.4 g |

The radical polymerization initiator OS-12 used in the negative recording layer coating liquid is shown above as an example of the onium salt represented by formula (I).

The structures of the infrared absorber (IR-1), additive (PM-1), polymerizable compound (AM-1), binder polymer (BT-1), and ethyl violet (C-1) are shown below.

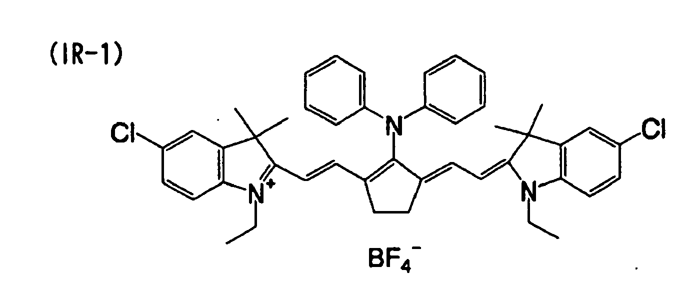

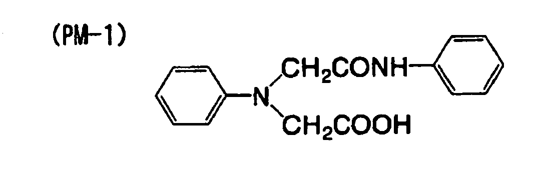

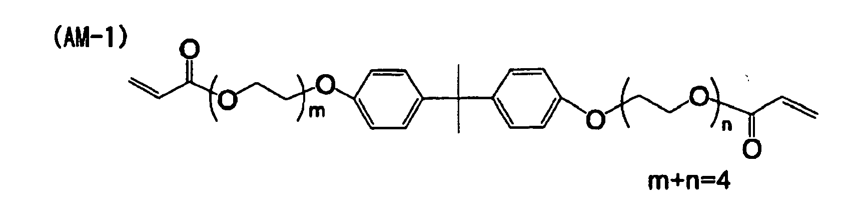

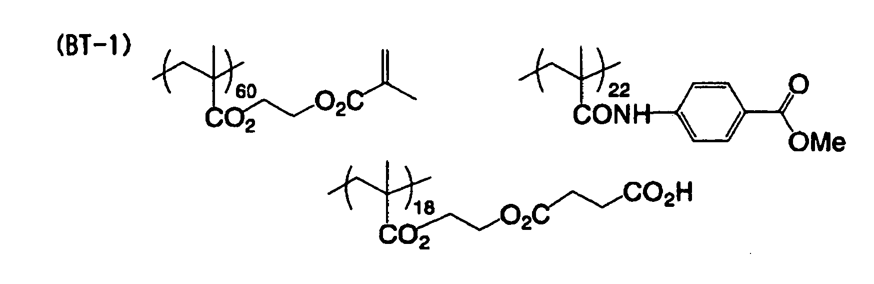

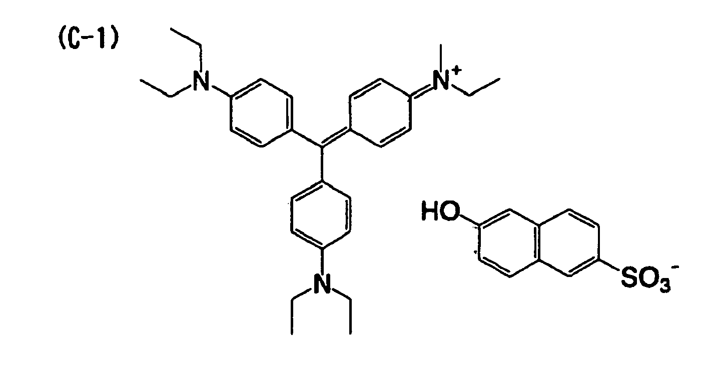

An overcoat layer coating liquid with the following composition was coated on the negative recording layer such that the dry coating amount of the overcoat layer was 1.5 g/m². Then, the coating liquid was dried at 120 °C for 1 minute, so that a planographic printing plate precursor was obtained.

### <Overcoat Layer Coating Liquid>

| | |
|---|---|
| Polyvinyl alcohol (PVA-203 manufactured by Kuraray Co., Ltd., having a saponification degree of 88 % by mol and a polymerization degree of 300) | 6.0 g |
| EMALEX 710 (a surfactant, manufactured by Nihon-Emulsion Co., Ltd.) | 0.1 g |
| LUVITEC VA64W (vinyl pyrrolidone-vinyl acetate copolymer, manufactured by ICP) | 0.4 g |
| PIONIN D-230 (polyoxyethylene caster oil ether, manufactured by Takemoto Oil & Fat) | 0.2 g |
| Water | 100.0 g |

### Evaluation of Planographic Printing Plate Precursor

The evaluation of the planographic printing plate precursor was conducted by using a CTP output system manufactured by Fuji Photo Film Co., Ltd. containing a printing plate precursor supplying unit (SA-L8000), an exposure unit (LUXEL T-9000CTP), a conveyer (T-9000 conveyer), an automatic processor (LP-1310 H, automatic developing unit), and a stocker (ST-1160). The developer was a solution obtained by diluting DH-N manufactured by Fuji Photo Film Co., Ltd. with water (DH-N : water = 1 : 4) and the developer had a pH of 12.05 at 25 °C. The developer was disposed in the development bath of the automatic processor. The replenisher was a solution obtained by diluting DH-NR manufactured by Fuji Photo Film Co., Ltd. with water (DH-NR : water = 1 : 4). The temperature of the development bath was 30 °C. The finisher was a solution obtained by diluting GN-2 manufactured by Fuji Photo Film Co., Ltd. with water (GN-2 : water =1:1).

30 negative planographic printing plate precursor sheets obtained in the above-described manner were stacked without using inserting paper. The stack was set in the planographic printing plate precursor supplying unit, and the respective sheets were continuously exposed, developed, and discharged to the stocker automatically. During the operation of the CTP output system, troubles such as conveyance troubles caused by adhesion of the sheets did not occur, and it was found that the planographic printing plate precursor of Example 1 had superior handling property.

### Example 2

An aluminum support was prepared in the same manner as in Example 1, except that the roughening (graining) of the back surface of the aluminum support was conducted in the same manner as that employed in the graining of the front surface. Specifically, the back surface of the aluminum support was subjected to the following electrolytic graining: the electrolytic graining was conducted in an aqueous solution containing 1 % of nitric acid and 0.5 % of aluminum nitrate at 45 °C with alternating electric current having a duty ratio of 1:1 at a current density of 20 A/dm² supplied by an indirect power supplying cell while the aluminum web was floating on the aqueous solution, and an anode electric quantity of 240 C/dm² was supplied to the aluminum support. The center line surface roughness Ra of the front and back surfaces of the obtained aluminum support was 0.5 µm. The Bekk smoothness of the back surface of the aluminum support was measured in the same manner as in Example 1, and found to be 120 seconds.

A negative recording layer and an overcoat layer were provided on the front surface of the aluminum support in the same manner as in Example 1, so that a planographic printing plate precursor of Example 2 was obtained.

### Comparative Example 1

An aluminum support was obtained in the same manner as in Example 1, except that the roughening of the back surface of the aluminum support was not conducted. The back surface of this aluminum support had an Ra of 0.1 µm. The Bekk smoothness of the back surface of the aluminum support was measured in the same manner as in Example 1 and was found to be 1,500 seconds.

A negative recording layer and an overcoat layer were provided on the front surface of the aluminum support in the same manner as in Example 1, so that a planographic printing plate precursor of Comparative Example 1 was obtained.

### Evaluation of Planographic Printing Plate Precursor

30 negative planographic printing plate precursor sheets of Example 2 were stacked without using inserting paper. The stack was set in the planographic printing plate precursor supplying unit, and the respective sheets were continuously exposed, developed, and discharged to the stocker automatically, in the same manner as in Example 1. During the operation of the CTP output system, troubles such as conveyance troubles caused by adhesion of the sheets did not occur, and it was found that the planographic printing plate precursor of Example 2 had superior handling property. Similarly, 30 negative planographic printing plate precursor sheets of Comparative Example 1 were stacked without using inserting paper. The stack was set in the planographic printing plate precursor supplying unit, and the respective sheets were continuously exposed, developed, and discharged to the stocker automatically, in the same manner as in Example 1. In Comparative Example 1, 17 sheets out of the 30 sheets caused conveyance troubles including stoppage of the planographic printing plate precursor feeding unit (SA-L8000) caused by failure to peel off individual sheets at feeding of the sheets and conveyance troubles on the conveyer caused by double feeding.

The planographic printing plate precursors of Examples 1 and 2 each had a back surface having a Beck smoothness of 1000 seconds or less. The back surface is formed by roughening the back surface of the aluminum support. Based on the above results, it was found that conveyance troubles did not occur when the stack of the planographic printing plate precursor sheets of Examples 1 and 2 not containing inserting paper is supplied to the CTP output system.

This is because the respective planographic printing plate sheets had superior peelability owing to weakened adhesion between the back surface of one sheet and the front surface of the next sheet in the stack of the sheets.

According to the invention, a planographic printing plate precursor with superior handling property is provided which enables weakened adhesion between the back surface of one planographic printing plate precursor sheet and the front surface of the next sheet upon stacking of the planographic printing plate precursor sheets without using inserting paper.

The invention also provides a stack of the planographic printing plate precursor sheets, and a method of making a planographic printing plate.

## Claims

1. A planographic printing plate precursor comprising an aluminium support having a hydrophilic front surface, wherein a negative recording layer is provided on the front surface, the negative recording layer including a polymerisable compound, a radiation absorber, and a compound that generates a radical upon application of radiation or heat, the aluminium support further comprising a back surface which is the back surface of the precursor, the back surface having a Bekk smoothness of 1000 seconds or less as measured by the method disclosed in JIS P 8119 (1998) and being obtainable by roughening followed by anodisation.

2. A planographic printing plate precursor according to Claim 1, wherein the amount of anodic oxide film on the back surface of the aluminium support is 0.1 g/m² or larger.

3. A planographic printing plate precursor according to Claim 1, wherein the surface roughness Ra of the back surface of the aluminium support is 0.15 to 0.7 µm.

4. A planographic printing plate precursor according to Claim 3, wherein the surface roughness Ra of the back surface of the aluminium support is 0.2 to 0.5 µm.

5. A planographic printing plate precursor according to Claim 1, wherein the planographic printing plate precursor further comprises an overcoat layer provided on the negative recording layer.

6. A stack of planographic printing plate precursors comprising a plurality of the planographic printing plate precursors of Claim 1, wherein the front surface of a planographic printing plate precursor contacts the back surface of a next planographic printing plate precursor.

7. A method of making planographic printing plates comprising the steps of:
setting the stack of planographic printing plate precursors of Claim 6 in a plate setter;
conveying the planographic printing plate precursors one by one; and
subjecting the respective planographic printing plate precursor to imagewise exposure.

## Patentansprüche

1. Flachdruckplattenvorläufer, der einen Aluminiumträger mit einer hydrophilen Vorderseitenoberfläche umfaßt, worin eine negative Aufzeichnungsschicht auf der Vorderseitenoberfläche vorgesehen ist, die negative Aufzeichnungsschicht eine polymerisierbare Verbindung, einen Strahlungsabsorber und eine Verbindung, die durch Einwirkung von Strahlung oder Wärme ein Radikal bildet, umfaßt, der Aluminiumträger ferner eine Rückseitenoberfläche umfaßt, die die Rückseitenoberfläche des Vorläufers ist, die Rückseitenoberfläche eine Bekk-Glätte von 1.000 Sekunden oder weniger, gemessen mit dem Verfahren, das in JIS P 8119 (1998) offenbart ist, aufweist und durch Aufrauhen, gefolgt von Anodisierung, erhältlich ist.

2. Flachdruckplattenvorläufer gemäß Anspruch 1, worin die Menge eines anodischen Oxidfilms auf der Rückseitenoberfläche des Aluminiumträgers 0,1 g/m² oder mehr beträgt.

3. Flachdruckplattenvorläufer gemäß Anspruch 1, worin die Oberflächenrauheit Ra der Rückseitenoberfläche des Aluminiumträgers 0,15 bis 0,7 µm beträgt.

4. Flachdruckplattenvorläufer gemäß Anspruch 3, worin die Oberflächenrauheit Ra der Rückseitenoberfläche des Aluminiumträgers 0,2 bis 0,5 µm beträgt.

5. Flachdruckplattenvorläufer gemäß Anspruch 1, worin der Flachdruckplattenvorläufer ferner eine Überzugsschicht umfaßt, die auf der negativen Aufzeichnungsschicht vorgesehen ist.

6. Stapel ("stack") von Flachdruckplattenvorläufern, der eine Vielzahl von Flachdruckplattenvorläufern gemäß Anspruch 1 umfaßt, worin die Vorderseitenoberfläche eines Flachdruckplattenvorläufers in Kontakt mit der Rückseitenoberfläche des nächsten Flachdruckplattenvorläufers steht.

7. Verfahren zum Herstellen von Flachdruckplatten, umfassend die Schritte:
Einsetzen des Stapels von Flachdruckplattenvorläufern gemäß Anspruch 6 in einen Plattensetzer;
einzelnes Befördern der Flachdruckplattenvorläufer; und
bildweises Belichten des entsprechenden Flachdruckplattenvorläufers.

## Revendications

1. Précurseur de plaque d'impression planographique comprenant un support en aluminium ayant une surface avant hydrophile, dans lequel une couche d'enregistrement en négatif est fournie sur la surface avant, la couche d'enregistrement en négatif incluant un composé polymérisable, un agent absorbant les radiations et un composé qui crée un radical lors de l'application d'une radiation ou de la chaleur, le support en aluminium comprenant en outre une surface arrière qui est la surface arrière du précurseur, la surface arrière ayant un lissé Bekk de 1 000 secondes ou moins tel que mesuré par le procédé décrit dans JIS P 8119 (1998) et que l'on peut obtenir en la rendant rugueuse suivi par une anodisation.

2. Précurseur de plaque d'impression planographique selon la revendication 1, dans lequel la quantité de film d'oxyde anodique sur la surface arrière du support en aluminium est de 0,1 g/m² ou davantage.

3. Précurseur de plaque d'impression planographique selon la revendication 1, dans lequel la rugosité de surface Ra de la surface arrière du support en aluminium est de 0,15 à 0,7 µm.

4. Précurseur de plaque d'impression planographique selon la revendication 3, dans lequel la rugosité de surface Ra de la surface arrière du support en aluminium est de 0,2 à 0,5 µm.

5. Précurseur de plaque d'impression planographique selon la revendication 1, dans lequel le précurseur de plaque d'impression planographique comprend en outre une couche de revêtement fournie sur la couche d'enregistrement négative.

6. Pile de précurseurs de plaque d'impression planographique comprenant une pluralité de précurseurs de plaque d'impression planographique selon la revendication 1, dans laquelle la surface avant d'un précurseur de plaque d'impression planographique est en contact avec la surface arrière d'un précurseur de plaque d'impression planographique suivant.

7. Procédé de fabrication de plaques d'impression planographique comprenant les étapes de :
réglage de la pile de précurseurs de plaque d'impression planographique selon la revendication 6 dans un compositeur de plaque ;
convoyage des précurseurs de plaque d'impression planographique un à un ; et
soumission du précurseur de plaque d'impression planographique respectif à une exposition aux fins d' image.
